(19) Europäisches Patentamt / European Patent Office / Office européen des brevets

(11) **EP 4 024 458 A1**

(12) **EUROPEAN PATENT APPLICATION**
published in accordance with Art. 153(4) EPC

(43) Date of publication:
06.07.2022 Bulletin 2022/27

(21) Application number: 19944764.0

(22) Date of filing: 10.09.2019

(51) International Patent Classification (IPC):
*H01L 27/146* (2006.01)   *G01B 11/14* (2006.01)
*H01L 31/0224* (2006.01)

(52) Cooperative Patent Classification (CPC):
G01B 11/14; H01L 27/146; H01L 31/0224

(86) International application number:
PCT/CN2019/105235

(87) International publication number:
WO 2021/046730 (18.03.2021 Gazette 2021/11)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Huawei Technologies Co., Ltd.
Longgang District
Shenzhen,
Guangdong 518129 (CN)

(72) Inventors:
• SHI, Chen
  Shenzhen, Guangdong 518129 (CN)
• PAN, Han
  Shenzhen, Guangdong 518129 (CN)
• GONG, Xiaofeng
  Shenzhen, Guangdong 518129 (CN)
• TANG, Yangyang
  Shenzhen, Guangdong 518129 (CN)

(74) Representative: Maiwald Patent- und
Rechtsanwaltsgesellschaft mbH
Elisenhof
Elisenstraße 3
80335 München (DE)

(54) **PIXEL STRUCTURE AND METHOD FOR MANUFACTURING SAME**

(57) Embodiments of this application disclose a pixel structure (2003) and a method for manufacturing a pixel structure (2003). The pixel structure (2003) includes: a modulation gate group, where the modulation gate group includes at least one first modulation gate (PGA) and at least one second modulation gate (PGB) that are disposed on a first surface (2011) of a substrate (201), and the at least one second modulation gate (PGB) and the at least one first modulation gate (PGA) are subject to complementary modulation; the substrate (201) , including at least two carrier storage regions respectively located on two sides of the substrate (201) in a first direction, where the first direction is a direction parallel to the first surface (2011); and a carrier collection region (202), located between the at least two carrier storage regions in the first direction, and in contact with the at least one first modulation gate and the at least one second modulation gate on the first surface (2011), where the carrier collection region (202) and the at least two carrier storage regions have a same doping type, the carrier collection region (202) and the substrate (201) have opposite doping types, and a doping concentration of the carrier collection region (202) is greater than a doping concentration of the substrate (201).

FIG. 7a

## Description

## TECHNICAL FIELD

Embodiments of this application relate to the field of semiconductor technologies, and in particular, to a pixel structure and a method for manufacturing a pixel structure.

## BACKGROUND

3D imaging based on time of flight (TOF) ranging is a technology that can measure a time of flight of a light wave to generate depth information. A modulated light wave generated by a laser is reflected by an object and then is received by a sensor. 3D information of the photographed object is obtained through conversion by calculating a time difference between light emission and reflection.

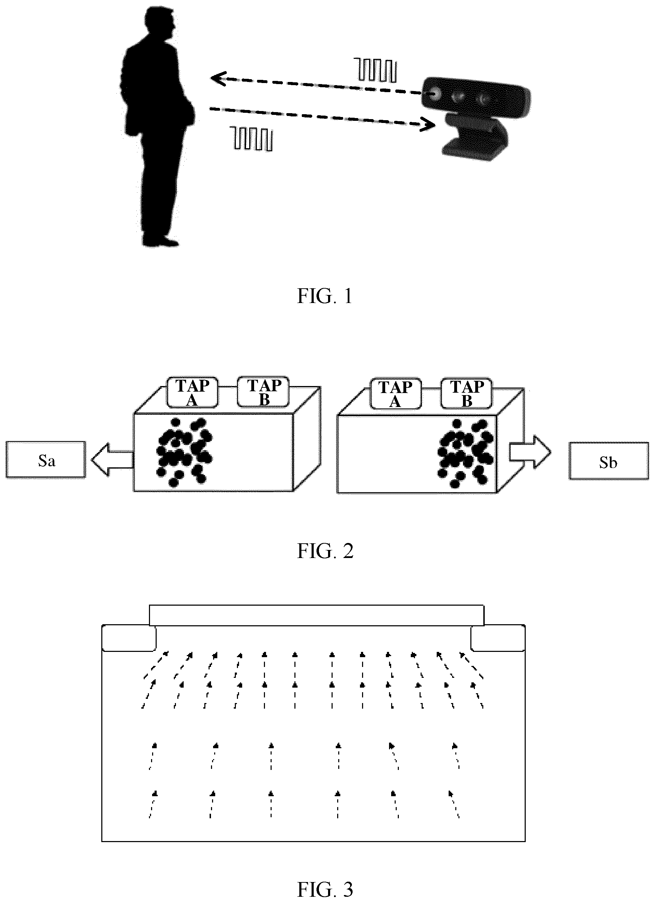

As shown in FIG. 1, an indirect time of flight (i-TOF) ranging technology is determining a phase difference between received reflected light and emitted light through comparison, and then calculating a time of flight, to obtain depth information of a measured object. A specific implementation method is to modulate and collect photo-generated carriers by using control signals of different phases to integrate the photo-generated carriers in different time periods, and finally calculate a phase difference between a reflected signal and an emitted signal.

As described above, a pixel design of i-TOF is to implement modulation inside a pixel structure, that is, collect and read photo-generated carriers generated by a component in different time periods. A specific design is shown in FIG. 2. Generally, there are two complementary TAPs: a TAP A and a TAP B. Ideally, Sa photo-generated carriers are generated in a time period A, which are all collected by the TAP A, and Sb photo-generated carriers are generated in another time period (a time period B), which are all collected by the TAP B. Generally, a frequency of switching between the TAP A and the TAP B is consistent with a modulation frequency of infrared light emitted by a laser. A performance indicator for evaluating whether the pixel design is good or bad is a modulation contrast (MC), which is also referred to as modulation and demodulation efficiency. The MC satisfies the following formula:

$$MC=(Sa-Sb)/(Sa+Sb) \text{ (Formula 1)}$$

Based on the foregoing, if light is emitted only in the time period A, the TAP A collects all the Sa photo-generated carriers, and the TAP B collects Sb=0 carrier. MC= 100% may be obtained by substituting Sb=0 into Formula 1. However, due to a non-ideal factor in a component design, some photo-generated carriers generated in the time period A are collected by the TAP B, and an actual MC is lower than 100%.

In 3D imaging, an object distance measured from an i-TOF camera is not 100% accurate due to factors such as noise and modulation frequency limitation. A basic idea to improve ranging accuracy is to allow pixels to absorb effective modulated light as much as possible, and distribute generated carriers to different gates more accurately. In addition, a higher frequency of a modulation process indicates higher accuracy.

Currently, to increase a spatial resolution of i-TOF cameras, a TOF pixel structure is developing towards a small pixel structure. The small pixel structure reduces an amount of admitted light, which reduces ranging accuracy of i-TOF. To compensate for the loss of the amount of admitted light, pixels of i-TOF need to obtain a high modulation contrast at a high modulation frequency.

A main factor affecting an MC at a high frequency (>100 MHz) is a carrier collection speed. As shown in FIG. 3, due to a low absorption coefficient of a silicon component for near infrared light, a TOF component needs relatively thick silicon (>4 $\mu$m) to absorb enough infrared light. However, a potential change at the bottom of the component is very small, resulting in a low speed of carriers, which take a long time to reach a collection point at the top.

If these carriers generated at the bottom are not effectively collected at a specified collection point in an enough short time, they are collected by another collection point in a subsequent time period, resulting in MC decrease and affecting ranging accuracy. Moreover, such an MC decrease problem caused by an excessively long carrier collection time is more serious at a high frequency.

## SUMMARY

Embodiments of this application provide a pixel structure and a method for manufacturing a pixel structure, to resolve a problem of low modulation and demodulation efficiency of a small pixel structure.

To achieve the foregoing objective, the following technical solutions are used in embodiments of this application.

According to a first aspect of the embodiments of this application, a pixel structure is provided, including: a modulation gate group, where the modulation gate group includes: at least one first modulation gate sequentially disposed on a first surface of a substrate, and at least one second modulation gate sequentially disposed on the first surface, where the at least one second modulation gate and the at least one first modulation gate are subject to complementary modulation; and the substrate, including: at least two carrier storage regions, where the at least two carrier storage regions include a first carrier storage region and a second carrier storage region respectively located on two sides of the substrate in a first direction, and the first direction is a direction parallel to the first surface; and a carrier collection region, located between the at least two carrier storage regions in the first direction, and in contact with the at least one first modulation gate and the at least one second modulation gate on the first surface, where the carrier collection region and the at least two carrier storage regions have a same doping type, and the carrier collection region and the substrate have opposite doping types. In this way, a PN junction depletion region is formed at a position where the carrier collection region is adjacent to the substrate, and substrate ions on two sides of the PN junction depletion region have opposite electrical properties, so that an electric field is generated. When the electric field is sufficient to prevent further transfer of holes and electrons, the PN junction depletion region reaches its equilibrium size.

In addition, a doping concentration of the carrier collection region is greater than a doping concentration of the substrate. In this way, in a process of forming the PN junction depletion region, the formed PN junction depletion region is more biased towards the substrate. When the substrate is irradiated by light, carriers are generated inside the substrate, and because the PN junction depletion region is more biased towards the substrate, the carriers in the substrate enter the carrier collection region under action of the electric field of the PN junction depletion region. In a conventional technology, a carrier concentration at a substrate bottom is low, and a potential change is limited to a shallow region inward from a surface, which leads to a low speed of carriers at the substrate bottom, and a long time required to reach a carrier collection point on the first surface, thereby affecting modulation and demodulation efficiency of the pixel structure. In this application, the substrate has more uniform potential changes from the first surface to the substrate bottom, thereby increasing the speed of the carriers at the substrate bottom, enabling the carriers to be collected quickly, improving modulation and demodulation efficiency of the pixel structure, and improving ranging accuracy.

In an optional implementation, the carrier collection region includes: a first doped region and a second doped region respectively located on two sides of the carrier collection region in the first direction; and a third doped region, located between the first doped region and the second doped region, where doping concentrations of the first doped region and the second doped region are both greater than a doping concentration of the third doped region. In this way, when the pixel structure is reset, all carriers in the substrate are concentrated on the first surface of the substrate. If the carrier collection region uses a single doping concentration, a local potential well is formed at a middle position of the substrate surface, resulting in that carriers cannot be extracted in a reset process. If the carrier collection region uses a doping mode in which the first doped region and the second doped region on the two sides of the carrier collection region have a high doping concentration and the third doped region at a middle position of the carrier collection region has a low doping concentration, formation of a local potential well in the middle is avoided, which helps smoothly extract carriers at a middle position of the first surface of the substrate in a reset process, and makes it easier to reset the pixel structure.

In an optional implementation, the at least two carrier storage regions include a first carrier storage region and a second carrier storage region, the first carrier storage region is close to the first modulation gate and far from the second modulation gate, and the second carrier storage region is close to the second modulation gate and far from the first modulation gate. The at least one first modulation gate and the at least one second modulation gate are disposed on the first surface along the first direction, the at least one first modulation gate includes a first end that is the closest to the first carrier storage region and a second end that is the farthest from the first carrier storage region, and the at least one second modulation gate includes a first end that is the closest to the second carrier storage region, and a second end that is the farthest from the second carrier storage region. The first doped region is located between the first end and the second end of the at least one first modulation gate in the first direction, and the second doped region is located between the first end and the second end of the at least one second modulation gate in the first direction. In this way, a distance for regulation of the first modulation gate is reserved between the first carrier storage region and the first doped region, and a distance for regulation of the second modulation gate is reserved between the second carrier storage region and the second doped region.

In an optional implementation, the doping concentration of the first doped region is 10 to 100 times the doping concentration of the third doped region, and the doping concentration of the second doped region is 10 to 100 times the doping concentration of the third doped region. In this way, a concentration difference between the first doped region and the third doped region and a concentration difference between the second doped region and the third doped region are increased, which helps reset the pixel structure.

In an optional implementation, the first doped region and the second doped region are symmetrically disposed relative to a first axis, and the third doped region is symmetric relative to the first axis. The first axis is perpendicular to the first surface. In this way, when the at least one first modulation gate and the at least one second modulation gate are subject to complementary modulation, carriers in the substrate have a same capability to enter the first carrier storage region and the second carrier storage region.

In an optional implementation, the at least one first modulation gate and the at least one second modulation gate are disposed on the first surface along the first direction, the at least two carrier storage regions include a first carrier storage region and a second carrier storage region, the first carrier storage region is close to the first modulation gate and far from the second modulation gate, and the second carrier storage region is close to the second modulation gate and far from the first modulation gate. The at least one first modulation gate includes a first end that is the closest to the first carrier storage region and a second end that is the farthest from the first carrier storage region, and the at least one second modulation gate includes a first end that is the closest to the second carrier storage region, and a second end that is the farthest from the second carrier storage region. The carrier collection region is located between the first end of the at least one first modulation gate and the first end of the at least one second modulation gate in the first direction. In this way, a distance for regulation of the first modulation gate is reserved between the first carrier storage region and the carrier collection region, and a distance for regulation of the second modulation gate is reserved between the second carrier storage region and the carrier collection region.

In an optional implementation, in a direction perpendicular to the first surface, a length of the carrier collection region is equal to a length of the substrate. In this way, a PN junction depletion region may be formed on the substrate on the two sides of the carrier collection region, so that carriers in the substrate on the two sides of the carrier collection region flow into the carrier collection region under action of an electric field of the PN junction depletion region, thereby improving modulation and demodulation efficiency of the pixel structure.

In an optional implementation, in a direction perpendicular to the first surface, a length of the carrier collection region is less than a length of the substrate. In this way, a PN junction depletion region may be formed at the substrate bottom, so that carriers at the substrate bottom may flow into the carrier collection region under action of an electric field of the PN junction depletion region, thereby improving modulation and demodulation efficiency of the pixel structure.

In an optional implementation, the carrier storage regions include a first carrier storage region close to the at least one first modulation gate, and a second carrier storage region close to the at least one second modulation gate. A first gate is disposed between the at least one first modulation gate and the first carrier storage region, and a second gate is disposed between the at least one second modulation gate and the second carrier storage region. The at least one first modulation gate and the at least one second modulation gate are configured to receive alternating current modulation signals, and the first gate and the second gate are configured to receive direct current modulation signals. In this way, the direct current signal received by the first gate may shield impact of the alternating current signal received by the at least one first modulation gate on the first carrier storage region. Similarly, the direct current signal received by the second gate may shield impact of the alternating current signal received by the at least one second modulation gate on the second carrier storage region.

In an optional implementation, the doping concentration of the carrier collection region is 1000 to 10000 times the doping concentration of the substrate. In this way, a concentration difference between the doping concentrations of the carrier collection region and the substrate is increased, which helps a PN junction depletion region to be biased towards the substrate, makes it easier for carriers in the substrate to enter the carrier collection region under action of an electric field, and improves modulation and demodulation efficiency of the pixel structure.

In an optional implementation, the carrier collection region uses P-type doping, and the substrate uses N-type doping; or the carrier collection region uses N-type doping, and the substrate uses P-type doping. This helps form a PN junction depletion region between the substrate and the carrier collection region, and improves modulation and demodulation efficiency of the pixel structure.

In an optional implementation, the modulation gate group further includes: at least one third modulation gate sequentially disposed on the first surface of the substrate, and at least one fourth modulation gate sequentially disposed on the first surface, where the at least one first modulation gate, the at least one second modulation gate, the at least one third modulation gate, and the at least one fourth modulation gate are subject to complementary modulation. The first modulation gate and the second modulation gate are symmetric with respect to a center of the first surface, and the third modulation gate and the fourth modulation gate are symmetric with respect to the center of the first surface. The at least two carrier storage regions further include a third carrier storage region and a fourth carrier storage region respectively located on two sides of the substrate in a second direction, the second direction is parallel to the first surface, and the second direction is perpendicular to the first direction. The carrier collection region is located between the third carrier storage region and the fourth carrier storage region in the second direction. In this way, modulation of the modulation gates is more flexible.

According to a second aspect of the embodiments of this application, a method for manufacturing a pixel structure is provided. The method includes: forming at least two carrier storage regions on a substrate through ion implantation, where the at least two carrier storage regions include a first carrier storage region and a second carrier storage region respectively located on two sides of the substrate in a first direction, and the first direction is a direction parallel to a first surface; forming a carrier collection region on the substrate through ion implantation, where the carrier collection region is located between the first carrier storage region and the second carrier storage region in the first direction, a doping concentration of the carrier collection region is greater than a doping concentration of the substrate, the carrier collection region and the at least two carrier storage regions have a same doping type, and the carrier collection region and the substrate have opposite doping types; and disposing at least one first modulation gate and at least one second modulation gate on the first surface of the substrate, where the at least one second modulation gate and the at least one first modulation gate are subject to complementary modulation, and the carrier collection region is in contact with the at least one first modulation gate and the at least one second modulation gate on the first surface.

In an optional implementation, the at least two carrier storage regions include a first carrier storage region and a second carrier storage region, the first carrier storage region is close to the first modulation gate and far from the second modulation gate, and the second carrier storage region is close to the second modulation gate and far from the first modulation gate. The at least one first modulation gate includes a first end that is the closest to the first carrier storage region and a second end that is the farthest from the first carrier storage region, and the at least one second modulation gate includes a first end that is the closest to the second carrier storage region, and a second end that is the farthest from the second carrier storage region. The disposing at least one first modulation gate and at least one second modulation gate on the first surface of the substrate includes: disposing the at least one first modulation gate and the at least one second modulation gate on the first surface along the first direction, so that the carrier collection region is located between the first end of the at least one first modulation gate and the first end of the at least one second modulation gate in the first direction.

In an optional implementation, the forming a carrier collection region on the substrate through ion implantation includes: forming a first doped region and a second doped region on the substrate through ion implantation, where the first doped region and the second doped region are respectively located on two sides of the carrier collection region in the first direction; and forming a third doped region on the substrate through ion implantation, where doping concentrations of the first doped region and the second doped region are both greater than a doping concentration of the third doped region, and the third doped region is located between the first doped region and the second doped region.

In an optional implementation, the forming a carrier collection region on the substrate through ion implantation includes: forming a first doped region and a second doped region on the substrate through ion implantation, where the first doped region and the second doped region are respectively located on two sides of the carrier collection region in the first direction; and diffusing ions of the first doped region and the second doped region to a third region to form a third doped region, where doping concentrations of the first doped region and the second doped region are both greater than a doping concentration of the third doped region, and the third doped region is located between the first doped region and the second doped region.

In an optional implementation, the at least two carrier storage regions include a first carrier storage region and a second carrier storage region, the first carrier storage region is close to the first modulation gate and far from the second modulation gate, and the second carrier storage region is close to the second modulation gate and far from the first modulation gate. The at least one first modulation gate includes a first end that is the closest to the first carrier storage region and a second end that is the farthest from the first carrier storage region, and the at least one second modulation gate includes a first end that is the closest to the second carrier storage region, and a second end that is the farthest from the second carrier storage region. The disposing at least one first modulation gate and at least one second modulation gate on the first surface of the substrate includes: disposing the at least one first modulation gate and the at least one second modulation gate on the first surface along the first direction, so that the first doped region is located between the first end and the second end of the at least one first modulation gate in the first direction, and the second doped region is located between the first end and the second end of the at least one second modulation gate in the first direction.

In an optional implementation, the doping concentration of the first doped region is 10 to 100 times the doping concentration of the third doped region, and the doping concentration of the second doped region is 10 to 100 times the doping concentration of the third doped region.

In an optional implementation, the first doped region and the second doped region are symmetrically disposed relative to a first axis, and the third doped region is symmetric relative to the first axis. The first axis is perpendicular to the first surface.

In an optional implementation, in a direction perpendicular to the first surface, a length of the carrier collection region is less than or equal to a length of the substrate.

In an optional implementation, the at least two carrier storage regions include a first carrier storage region close to the at least one first modulation gate, and a second carrier storage region close to the at least one second modulation gate. The method further includes: disposing a first gate between the at least one first modulation gate and the first carrier storage region; and disposing a second gate between the at least one second modulation gate and the second carrier storage region, where the first modulation gate and the second modulation gate are configured to receive alternating current modulation signals, and the first gate and the second gate are configured to receive direct current modulation signals.

In an optional implementation, the doping concentration of the carrier collection region is 1000 to 10000 times the doping concentration of the substrate.

In an optional implementation, the carrier collection region uses P-type doping, and the substrate uses N-type doping; or the carrier collection region uses N-type doping, and the substrate uses P-type doping.

In an optional implementation, the modulation gate group further includes: at least one third modulation gate sequentially disposed on the first surface of the substrate, and at least one fourth modulation gate sequentially disposed on the first surface, where the at least one first modulation gate, the at least one second modulation gate, the at least one third modulation gate, and the at least one fourth modulation gate are subject to complementary modulation. The first modulation gate and the second modulation gate are symmetric with respect to a center of the first surface, and the third modulation gate and the fourth modulation gate are symmetric with respect to the center of the first surface. The at least two carrier storage regions further include a third carrier storage region and a fourth carrier storage region respectively located on two sides of the substrate in a second direction, the second direction is parallel to the first surface, and the second direction is perpendicular to the first direction. The carrier collection region is located between the third carrier storage region and the fourth carrier storage region in the second direction.

## BRIEF DESCRIPTION OF DRAWINGS

FIG. 1 is a schematic diagram of i-TOF image acquisition in a conventional technology;
FIG. 2 is a schematic diagram of carrier transmission in a pixel structure in a conventional technology;
FIG. 3 is another schematic diagram of carrier transmission in a pixel structure in a conventional technology;
FIG. 4 is a schematic diagram of a structure of a terminal device according to an embodiment of this application;
FIG. 5 is a schematic diagram of a structure of a display module in FIG. 4;
FIG. 6a is a schematic diagram of a structure of another terminal device according to an embodiment of this application;
FIG. 6b is a schematic diagram of depth image acquisition according to an embodiment of this application;
FIG. 7 is a schematic diagram of a structure of a camera in FIG. 6b;
FIG. 7a is a top view of a pixel structure according to an embodiment of this application;
FIG. 7b is a cutaway drawing along A-A in FIG. 7a;
FIG. 7c is a schematic diagram of carrier transmission in a pixel structure in FIG. 7b;
FIG. 7d is a top view of another pixel structure according to an embodiment of this application;
FIG. 8 is a curve diagram of an internal potential change of a pixel structure according to an embodiment of this application;
FIG. 9 is a schematic diagram of another pixel structure according to an embodiment of this application;
FIG. 10 is a curve diagram of a potential change of a first surface of a pixel structure according to an embodiment of this application;
FIG. 11 is a schematic diagram of a structure of another pixel structure according to an embodiment of this application;
FIG. 12a is a schematic diagram of a structure of another pixel structure according to an embodiment of this application;
FIG. 12b is a schematic diagram of a structure of another pixel structure according to an embodiment of this application;
FIG. 13a is a schematic diagram of a structure of another pixel structure according to an embodiment of this application;
FIG. 13b is a schematic diagram of a structure of another pixel structure according to an embodiment of this application;
FIG. 14 is a schematic diagram of a structure of another pixel structure according to an embodiment of this application;
FIG. 15 is a flowchart of a method for manufacturing a pixel structure according to an embodiment of this application;
FIG. 15a, FIG. 15b, and FIG. 15c are schematic diagrams of product structures obtained after steps in FIG. 15 are performed;
FIG. 16 is a flowchart of another method for manufacturing a pixel structure according to an embodiment of this application;
FIG. 16a and FIG. 16b are schematic diagrams of product structures obtained after steps in FIG. 16 are performed;
FIG. 17 is a flowchart of another method for manufacturing a pixel structure according to an embodiment of this application;
FIG. 18 is a flowchart of another method for manufacturing a pixel structure according to an embodiment of this application; and
FIG. 18a is a schematic diagram of a product structure obtained after a step in FIG. 18 are performed.

## DESCRIPTION OF EMBODIMENTS

To make objectives, technical solutions, and advantages of this application clearer, the following further describes this application in detail with reference to the accompanying drawings.

The following terms "first" and "second" are merely intended for a purpose of description, and shall not be understood as an indication or implication of relative importance or implicit indication of a quantity of indicated technical features. Therefore, a feature limited by "first", "second", or the like may explicitly or implicitly include one or more features. In the description of this application, unless otherwise stated, "a plurality of" means two or more than two.

In addition, in this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

The following explains terms that may appear in embodiments of this application.

N-type doping (N is the initial of Negative, and this name comes from negative charges of electrons): In a silicon crystal (or germanium crystal) doped with a small quantity of impurity phosphorus elements (or antimony elements), because semiconductor atoms (such as silicon atoms) are replaced by impurity atoms, four of five outer electrons at an outer layer of a phosphorus atom form a covalent bond with a surrounding semiconductor atom, and the extra one electron is almost unbound and easily becomes a free electron. Therefore, an N-type semiconductor becomes a semiconductor with a relatively high electron concentration, whose conductivity mainly comes from conduction of the free electron.

P-type doping (P is the initial of Positive, and this name comes from positive charges of holes): In a silicon crystal (or germanium crystal) doped with a small quantity of impurity boron elements (or indium elements), because semiconductor atoms (such as silicon atoms) are replaced by impurity atoms, when three outer electrons at an outer layer of a boron atom form a covalent bond with a surrounding semiconductor atom, a "hole" is generated, and the hole may attract a bound electron to "fill", so that the boron atom becomes an ion with a negative charge. In this way, due to a relatively high concentration of "holes" ("equivalent to" positive charges), such a semiconductor becomes a substance that can conduct electricity.

PN junction depletion layer: An N-type semiconductor has excessive free electrons compared to a P-type region, and a P-type semiconductor has excessive holes compared to an N-type region. Therefore, when N-doped and P-doped semiconductor chips are placed together to form a junction, electrons are transferred to a P side and holes are transferred to an N side. Departure of the electrons from the N side to the P side leaves positive donor ions behind the N side, and also leaves negative acceptor ions on the P side.

After the transfer, diffused electrons are in contact with holes on the P side, which are eliminated by recombination. The same is true for diffused holes on the N side. Finally, the diffused electrons and holes disappear, and charged ions adjacent to an interface are left in a region without moving carriers (this is why it is referred to as a depletion region and carriers are depleted). Uncompensated ions are positive on the N side and negative on the P side. This creates an electric field that provides power against constant exchange of charge carriers. When the electric field is sufficient to prevent further transfer of holes and electrons, the depletion region reaches its equilibrium size.

Carrier: There are two types of carriers in semiconductors: electrons and holes, which are charged particles that can perform directional movement under action of an electric field.

Ion implantation: When an ion beam in a vacuum is emitted to a solid material, the ion beam gradually slows down due to resistance of the solid material and finally stays in the solid material. Such a phenomenon is referred to as ion implantation.

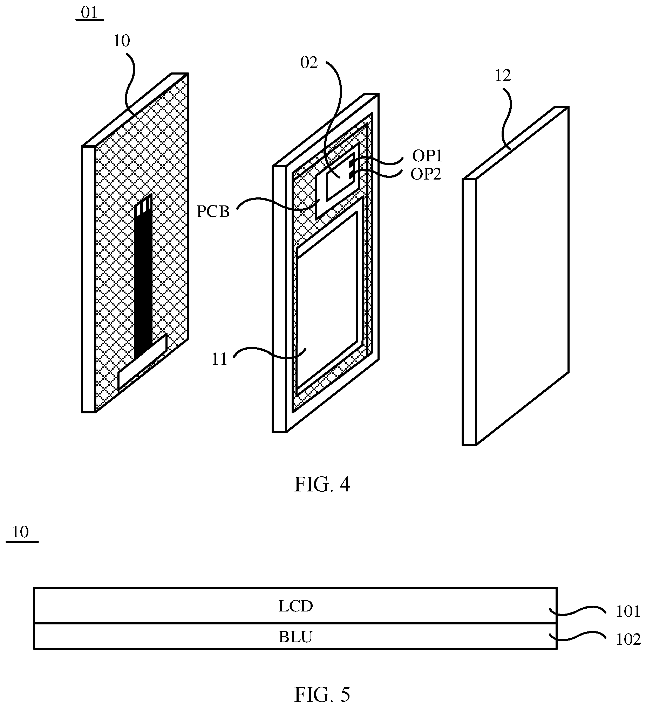

An embodiment of this application provides a terminal device. The terminal device includes, for example, a mobile phone, a tablet computer, a personal digital assistant (PDA), and an in-vehicle computer. A specific form of the terminal device is not specially limited in embodiments of this application. For ease of description, an example in which the terminal device is a mobile phone shown in FIG. 4 is used below for description.

As shown in FIG. 4, the terminal device 01 mainly includes, but is not limited to, a display module 10, a middle frame 11, and a rear cover 12. A side of the middle frame 11 facing the display module 10 is configured to carry the display module 10, and a side facing the rear cover 12 is provided with internal components such as a battery, a printed circuit board (PCB), a camera, and an antenna. The rear cover 12 is fastened to the middle frame 11, and is configured to protect the internal components.

In some embodiments of this application, as shown in FIG. 5, the display module 10 includes a display panel (DP) 101. The display panel 101 may be a liquid crystal display (LCD). In this case, the display module 10 further includes a backlight unit (BLU) 102 configured to provide a light source to the LCD.

Alternatively, in some other embodiments of this application, the display panel 101 may be an organic light-emitting diode (OLED) display panel. The OLED display panel can implement independent light emission. Therefore, the BLU 102 does not need to be set for the display module 10.

In addition, the foregoing description is provided by using an example in which the terminal device 01 includes one display module 10. In some embodiments, the terminal device 01 may include one or at least two display modules 10.

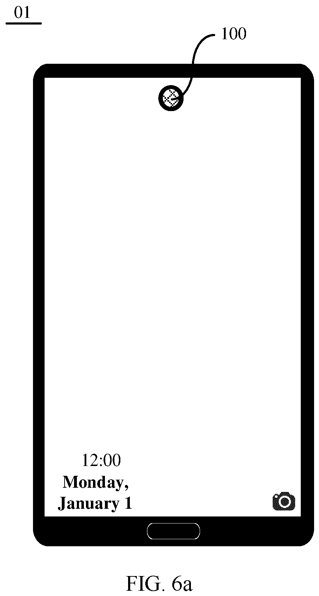

In addition, as an integration degree of the terminal device 01 increases, the terminal device 01 may further include a camera 100 shown in FIG. 6a. The camera 100 may be a depth camera, and can obtain depth information of a photographed object, to implement gesture recognition, face recognition, and the like.

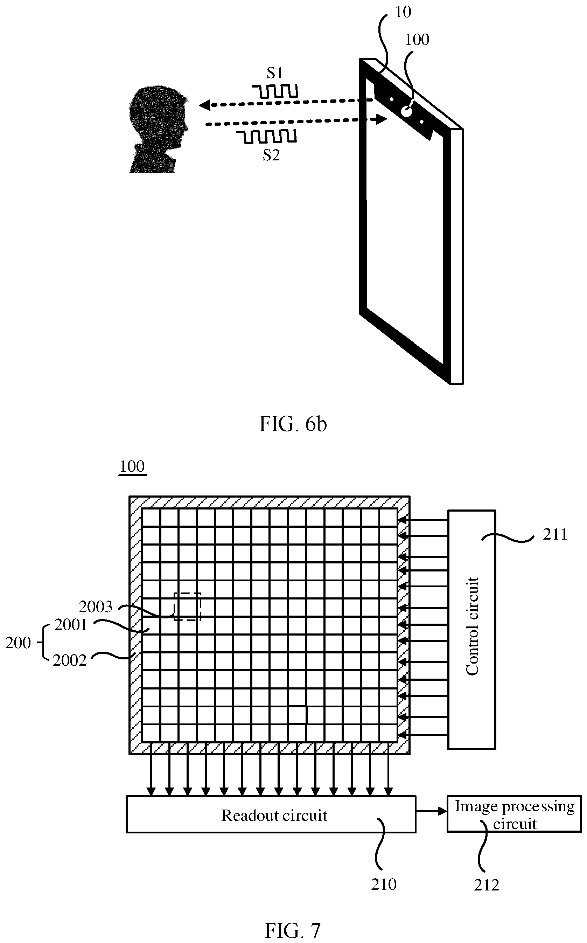

The camera 100 may use a 3D imaging technology based on TOF. As shown in FIG. 6b, the camera 100 sends a modulated emitted optical signal S1 to a photographed object, such as a face. After the optical signal S1 is reflected by the face, a reflected optical signal S2 formed is received by the camera 100. In this way, the camera 100 can obtain depth information (that is, distance information) of the measured object by calculating a time difference between the emitted optical signal S 1 and the reflected optical signal S2, to implement face recognition. In some embodiments, the terminal device 01 may include at least one camera 100.

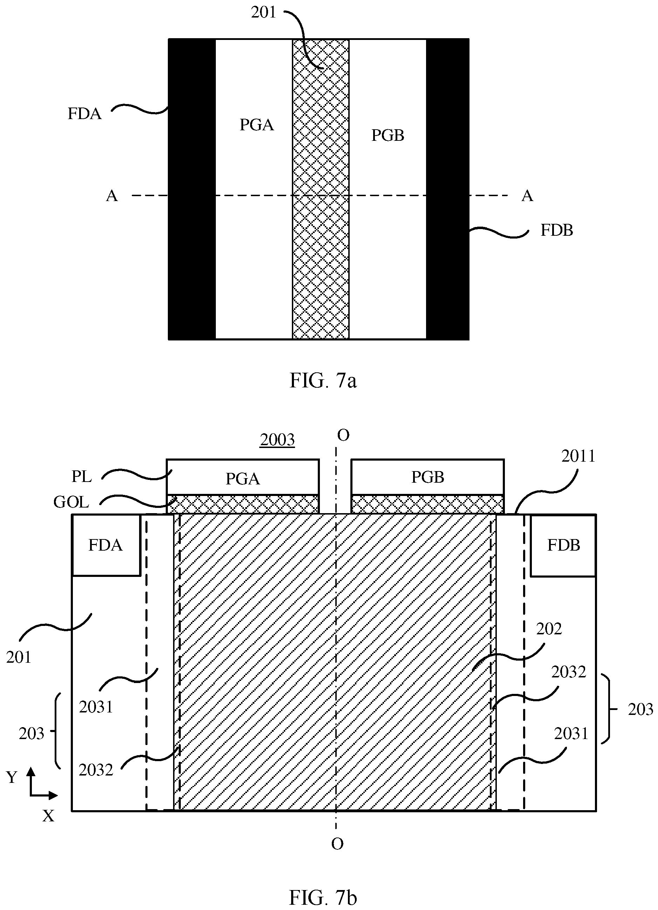

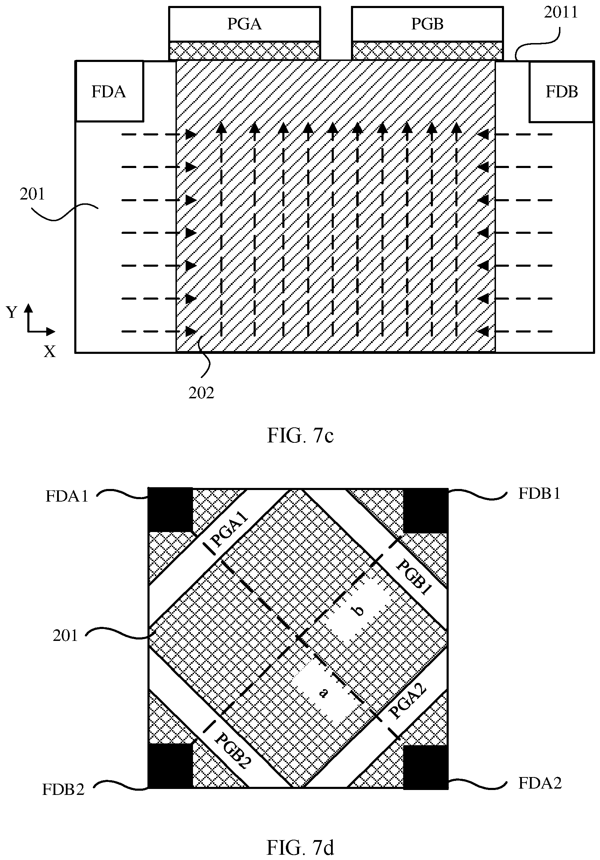

In some embodiments of this application, the camera 100 includes a lens and an image sensor 200 shown in FIG. 7. The image sensor 200 includes a plurality of pixel cells 2001 and a substrate 2002. Each pixel cell 2001 and a substrate disposed below the pixel cell 2001 form a pixel structure 2003.

The camera 100 further includes a readout circuit 210 and a control circuit 211 that are coupled to a pixel circuit of the pixel cell 2001, and an image processing circuit 212. The control circuit 211 may perform optical-to-electrical conversion by using the pixel cell 2001, and transmit an electrical signal obtained after the conversion to the readout circuit 210 at a readout time of the pixel circuit. The readout circuit 210 may perform analog-to-digital conversion and signal amplification on the input signal.

Next, the readout circuit 210 transmits a processed electrical signal to the image processing circuit 212. The image processing circuit 212 may generate a digital image signal based on the received electrical signal by using an image signal processing (ISP) technology, and convert the digital image signal into depth information through digital signal processing (DSP).

FIG. 7a is a top view of a pixel structure according to an embodiment of this application. FIG. 7b is a cutaway drawing along A-A in FIG. 7a. As shown in FIG. 7a and FIG. 7b, the pixel structure 2003 includes a substrate 201. A material of the substrate is not limited in this embodiment of this application. For example, the material of the substrate may be silicon.

A modulation gate group is disposed on the substrate, and the modulation gate group includes at least one first modulation gate and at least one second modulation gate. The at least one first modulation gate is sequentially disposed on a first surface 2011 of the substrate 201, the at least one second modulation gate is sequentially disposed on the first surface 2011, and the at least one second modulation gate and the at least one first modulation gate are subject to complementary modulation.

There may be one or more first modulation gates and second modulation gates. FIG. 7b shows one as an example for description.

As shown in FIG. 7b, the first modulation gate includes a first left modulation gate PGA.

The second modulation gate includes a first right modulation gate PGB.

It should be noted that the "PG" is an English abbreviation of a photo gate (grating diode).

That the at least one first modulation gate and the at least one second modulation gate are subject to complementary modulation may be: In a time period A, the first left modulation gate PGA is turned on, and the first right modulation gate PGB is turned off.

In another time period other than the time period A, for example, in a time period B, the first right modulation gate PGB is turned on, and the first left modulation gate PGA is turned off. Based on the foregoing, it may be considered that the first left modulation gate PGA and the first right modulation gate PGB are subject to complementary modulation.

The first surface 2011 may be any surface of the substrate 201. In this embodiment of this application, the first surface 2011 is a surface that is of the substrate and that is configured to collect carriers, both the at least one first modulation gate and the at least one second modulation gate are disposed on the first surface 2011, and a carrier collection region 202 is in contact with the at least one first modulation gate and the at least one second modulation gate.

In some embodiments of this application, when the transistor is an N-type transistor, a material that constitutes the semiconductor substrate 201 may be a P-type semiconductor material. Further, a gate of each transistor may include a gate oxide layer (GOL) close to the semiconductor substrate 201, and a polysilicon layer (PL) on a side surface of the gate oxide layer far from the semiconductor substrate 201.

The substrate 201 may include at least two carrier storage regions and the carrier collection region 202.

The at least two carrier storage regions are respectively located on two sides of the substrate 201 in a first direction, the first direction is a direction parallel to the first surface 2011, and the carrier collection region 202 is located between the two carrier storage regions in the first direction. The first direction may be a direction of an X axis in FIG. 7a.

There may be two or more carrier storage regions.

As shown in FIG. 7d, in an implementation of this application, there are four carrier storage regions: a first carrier storage region FDA1, a second carrier storage region FDA2, a third carrier storage region FDB1, and a fourth carrier storage region FDB2. The first carrier storage region FDA1, the second carrier storage region FDA2, the third carrier storage region FDB1, and the fourth carrier storage region FDB2 are respectively located on four corners of the first surface.

The modulation gate group includes a first modulation gate PGA1, a second modulation gate PGA2, a third modulation gate PGB1, and a fourth modulation gate PGB2. The first modulation gate PGA1 and the second modulation gate PGA2 are symmetric with respect to a center of the first surface, and the third modulation gate PGB 1 and the fourth modulation gate PGB2 are symmetric with respect to the center of the first surface. The first modulation gate PGA1, the second modulation gate PGA2, the third modulation gate PGB1, and the fourth modulation gate PGB2 may be subject to complementary modulation.

In a time period A, the first modulation gate PGA1 is turned on, the second modulation gate PGA2, the third modulation gate PGB1, and the fourth modulation gate PGB2 are turned off, and the first carrier storage region FDA1 is configured to collect carriers of the first modulation gate PGA1.

In a time period B, the second modulation gate PGA2 is turned on, the first modulation gate PGA1, the third modulation gate PGB1, and the fourth modulation gate PGB2 are turned off, and the second carrier storage region FDA2 is configured to collect carriers of the second modulation gate PGA2.

In a time period C, the third modulation gate PGB1 is turned on, the first modulation gate PGA1, the second modulation gate PGA2, and the fourth modulation gate PGB2 are turned off, and the third carrier storage region FDB1 is configured to collect carriers of the third modulation gate PGB1.

In a time period D, the fourth modulation gate PGB2 is turned on, and the first modulation gate PGA1, the second modulation gate PGA2, and the third modulation gate PGB1 are turned off, and the fourth carrier storage region FDB2 is configured to collect carriers of the fourth modulation gate PGB2.

The first carrier storage region FDA1 and the second carrier storage region FDA2 are located on two sides of the substrate in a first direction. The first direction is, for example, the same as an extension direction of a diagonal a in FIG. 7d.

The carrier collection region is located between the first carrier storage region FDA1 and the second carrier storage region FDA2 in the first direction.

The third carrier storage region FDB1 and the fourth carrier storage region FDB2 are located on two sides of the substrate in a second direction.

The carrier collection region is located between the third carrier storage region FDB1 and the fourth carrier storage region FDB2 in the second direction. The second direction is, for example, the same as an extension direction of a diagonal b in FIG. 7d.

For cutaway drawings along the diagonal line a and the diagonal line b in FIG. 7d, refer to the description in FIG. 7b. Details are not described herein again.

In another implementation of this application, as shown in FIG. 7a, there are two carrier storage regions. The carrier storage regions may include a first carrier storage region FDA located on a left side of the substrate 201 and a second carrier storage region FDB located on a right side of the substrate 201.

The first carrier storage region FDA is configured to collect carriers in the PGA, and the second carrier storage region FDB is configured to collect carriers in the PGB.

It should be noted that the "FG" is an English abbreviation of floating diffusion.

The following still uses two carrier storage regions as an example for description.

When the substrate receives infrared light irradiation, carriers are generated inside the substrate, and the carrier collection region 202 collects the carriers in the substrate 201. Under modulation of the first left modulation gate PGA or the first right modulation gate PGB, the carriers in the substrate 201 are stored in the first carrier storage region FDA through the first left modulation gate PGA or stored in the second carrier storage region FDB through the first right modulation gate PGB.

Next, referring to FIG. 7a, the carrier collection region 202, the first carrier storage region FDA, and the second carrier storage region FDB have a same doping type, and the carrier collection region 202 and the substrate 201 have opposite doping types.

Specific doping types of the carrier collection region 202 and the substrate 201 are not limited in this embodiment of this application. For example, in an implementation of this application, the carrier collection region 202, the first carrier storage region FDA, and the second carrier storage region FDB may use P-type doping, and the substrate 201 may use N-type doping.

Free electrons in the carrier collection region 202 are diffused into the substrate 201, and holes in the substrate 201 are diffused into the carrier collection region 202. The diffused electrons and holes are in contact and are eliminated by recombination, so that a PN junction depletion region 203 is formed at a position where the carrier collection region 202 is adjacent to the substrate 201. Charged ions adjacent to an interface are left in a region without moving carriers, and uncompensated ions are positive on the substrate 201 side and negative on the carrier collection region 202 side, which creates an electric field that provides power against constant exchange of charge carriers. When the electric field is sufficient to prevent further transfer of holes and electrons, the PN junction depletion region 203 reaches its equilibrium size.

In another implementation of this application, the carrier collection region 202, the first carrier storage region FDA, and the second carrier storage region FDB use N-type doping, and the substrate 201 uses P-type doping. Holes in the carrier collection region 202 are diffused into the substrate 201, and free electrons in the substrate 201 are diffused into the carrier collection region 202. The diffused electrons and holes are in contact and are eliminated by recombination, so that a PN junction depletion region 203 is formed at a position where the carrier collection region 202 is adjacent to the substrate 201.

A doping concentration of the carrier collection region 202 may be greater than a doping concentration of the substrate 201. For example, the doping concentration of the carrier collection region 202 is 1000 to 10000 times the doping concentration of the substrate 201. Electrons or holes are easily transferred from a high concentration region to a low concentration region until they are uniformly distributed. Therefore, the electrons or the holes in the carrier collection region 202 are more easily transferred to the substrate 201 in a process of forming the PN junction depletion region, and the formed PN junction depletion region 203 is more biased towards the substrate 201.

As shown in FIG. 7b, the PN junction depletion region 203 includes a first PN junction depletion region 2031 located in the substrate 201 and a second PN junction depletion region 2032 located in the carrier collection region 202. A range of the first PN junction depletion region 2031 is greater than a range of the second PN junction depletion region 2032.

As shown in FIG. 7c, when the substrate 201 is irradiated by light, carriers are generated inside the substrate 201. Ions on two sides of the PN junction depletion region 203 have opposite electrical properties, which generates a transverse electric field. Because the PN junction depletion region 203 is more located in the substrate 201, the electric field acts more on the carriers in the substrate 201, so that the carriers in the substrate 201 enter the carrier collection region 202.

Next, referring to FIG. 7c, the carrier collection region 202 may be in contact with the first left modulation gate PGA and the first right modulation gate PGB on the first surface 2011. The carriers in the substrate 201 may flow to the first surface 2011 under modulation of the first left modulation gate PGA and the first right modulation gate PGB, and then flow to the first carrier storage region FDA through the first left modulation gate PGA, or flow to the second carrier storage region FDB through the first right modulation gate PGB.

For example, in the time period A, the first left modulation gate PGA is turned on, the first right modulation gate PGB is turned off, and under modulation of the first left modulation gate PGA, the carriers in the substrate flow to the first surface of the substrate, and then are stored in the FDA.

In the time period B, the first right modulation gate PGB is turned on, the first left modulation gate PGA is turned off, and under modulation of the first right modulation gate PGB, the carriers in the substrate flow to the first surface of the substrate, and then are stored in the FDB.

Assuming that a quantity of carriers in the first carrier storage region FDA is Sa and a quantity of carriers in the second carrier storage region FDB is Sb, modulation and demodulation efficiency of the pixel structure may be obtained by substituting Sa and Sb into Formula 1.

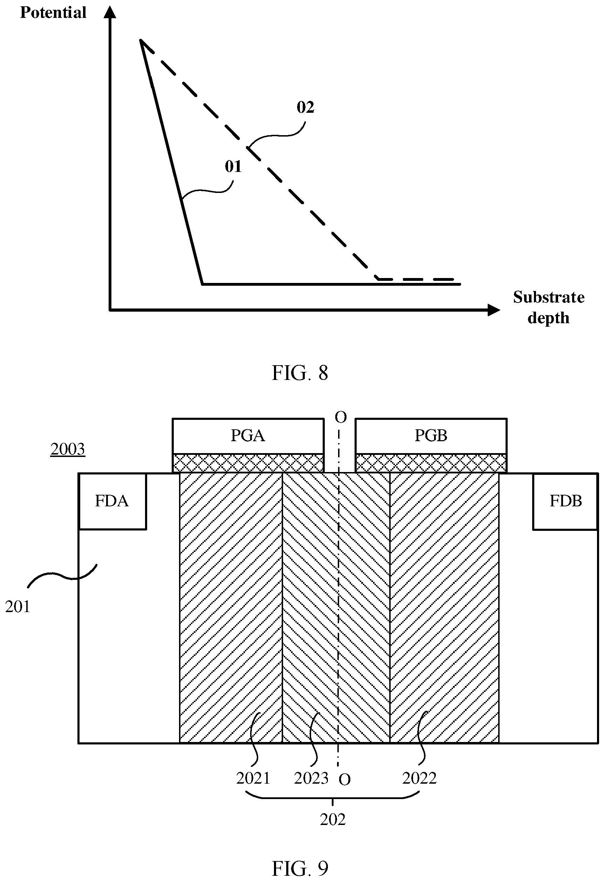

FIG. 8 is a curve diagram of a change of a potential inside a substrate with a substrate depth according to an embodiment of this application. As shown in FIG. 8, a vertical coordinate is the potential, and a horizontal coordinate is the substrate depth. The substrate depth is a vertical distance between each point in the substrate and the first surface 2011 of the substrate.

A line 01 is a curve of a change of a potential inside a substrate with a substrate depth in a conventional technology. A line 02 is a curve of the change of the potential inside the substrate with the substrate depth in this embodiment of this application.

In the conventional technology, a carrier concentration at a substrate bottom is low, and the potential is flat, so that the potential change in the substrate is limited to a very shallow region. Compared with the conventional technology, this embodiment of this application improves the carrier concentration at the substrate bottom by disposing the carrier collection region, so that the potential inside the substrate uniformly changes, increasing steepness of the potential inside the substrate, and helping increase a speed of carriers at the bottom of the pixel structure.

In the pixel structure provided in this embodiment of this application, the PN junction depletion region is formed at the position where the carrier collection region is adjacent to the substrate. The doping concentration of the carrier collection region is greater than the doping concentration of the substrate, so that the electrons or the holes in the carrier collection region are more easily diffused into the substrate in the process of forming the PN junction depletion region, and the formed PN junction depletion region is more biased towards the substrate. The substrate ions on the two sides of the PN junction depletion region have opposite electrical properties, so that an electric field is generated. When the substrate is irradiated by light, carriers are generated inside the substrate, and because the PN junction depletion region is more biased towards the substrate, the electric field on the two sides of the PN junction depletion region acts more on the carriers inside the substrate, and the carriers in the substrate enter the carrier collection region under action of the electric field of the PN junction depletion region. In the conventional technology, the carrier concentration at the substrate bottom is low, and the potential change is limited to a shallow region inward from a surface, which leads to a low speed of carriers at the substrate bottom, and a long time required to reach a carrier collection point on the first surface, thereby affecting modulation and demodulation efficiency of the pixel structure. In this application, the substrate has more uniform potential changes from the first surface to the substrate bottom, thereby increasing the speed of the carriers at the substrate bottom, enabling the carriers to be collected quickly, improving modulation and demodulation efficiency of the pixel structure, and improving ranging accuracy.

In some possible embodiments, as shown in FIG. 7b, the pixel structure 2003 is a structure that is left-right symmetric with respect to a centerline O-O, and the first left modulation gate PGA, the first right modulation gate PGB, the FDA, and the FDB are all symmetric with respect to the centerline O-O of the pixel structure 2003. In this way, the FDA and the FDB have a same capability to absorb the carriers in the substrate 201.

A structure of the carrier collection region 202 is not limited in this embodiment of this application. In an implementation of this application, as shown in FIG. 7b, the carrier collection region 202 has a single doping concentration, and the doping concentration does not change in the first direction.

In another implementation of this application, the doping concentration of the carrier collection region 202 presents "dense-shallow-dense" doping distribution in the first direction. As shown in FIG. 9, the carrier collection region 202 may include: a first doped region 2021, a second doped region 2022, and a third doped region 2023. The first doped region 2021 and the second doped region 2022 are respectively located on two sides of the carrier collection region 202 in the first direction. The third doped region 2023 is located between the first doped region 2021 and the second doped region 2022.

Doping concentrations of the first doped region 2021 and the second doped region 2022 are both greater than a doping concentration of the third doped region 2023.

For example, the doping concentration of the first doped region 2021 is 10 to 100 times the doping concentration of the third doped region 2023, and the doping concentration of the second doped region 2022 is 10 to 100 times the doping concentration of the third doped region 2023.

When the carrier collection region uses doping with a single concentration, when the pixel structure is reset, a local potential well is formed in a center of the carrier collection region on the substrate surface, which makes it difficult for carriers at the center of the first surface to enter the carrier collection region, and does not help reset the pixel structure.

If the carrier collection region uses the "dense-shallow-dense" doping mode, when the pixel structure is reset, no local potential trap is formed in the center of the carrier collection region on the substrate surface, which helps smoothly extract the carriers on the first surface of the substrate in a reset process, and makes it easier to reset the pixel structure.

The third doped region 2023 having the same doping type and a lower doping concentration is disposed in the carrier collection region 202, so that it is easier to reset the pixel structure.

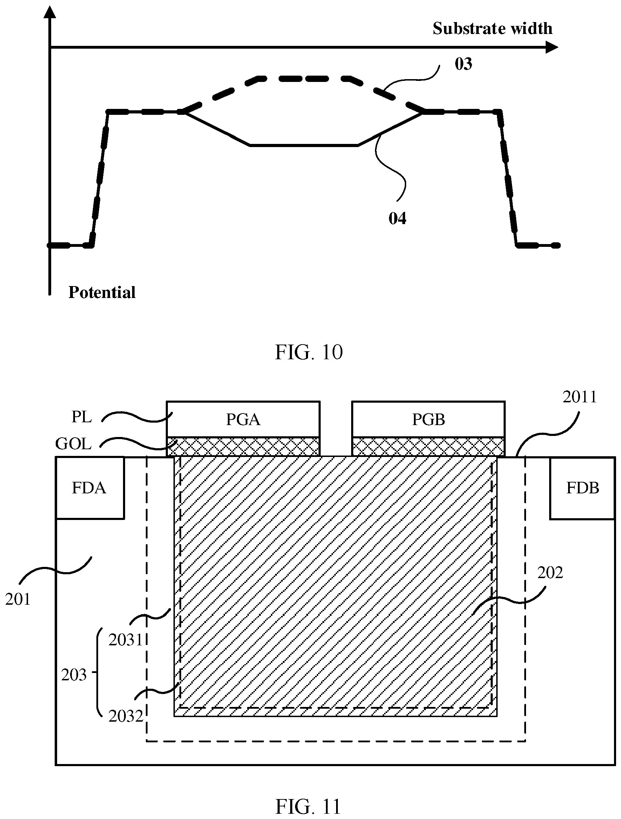

A specific description is provided below with reference to FIG. 10 by using an example in which the substrate 201 uses P-type doping and the carrier collection region 202 uses N-type doping.

FIG. 10 is a curve diagram of potential distribution of a first surface of a substrate when a pixel structure is reset according to an embodiment of this application. As shown in FIG. 10, a vertical coordinate is a potential, and a horizontal coordinate is a substrate width. The substrate width may be a vertical distance from any point of the first surface of the substrate to the first carrier storage region.

When the substrate 201 uses P-type doping and the carrier collection region 202 uses N-type doping, carriers reaching the first surface are electrons.

A line 04 is a curve of potential distribution on the first surface 2011 of the substrate when the carrier collection region uses a doping mode with a single concentration and the pixel structure is reset. As shown by the line 04, when the carrier collection region uses doping with a single concentration, the potential at the middle position of the first surface presents a local "concave" region in an opposite direction, and carriers at the middle position cannot flow to two sides under action of an applied electric field, resulting in that the electrons at the middle position cannot be smoothly extracted in a reset process.

A line 03 is a curve of potential distribution on the first surface 1011 of the substrate when the carrier collection region uses the "dense-shallow-dense" doping mode and the pixel structure is reset. As shown by the line 03, when the carrier collection region uses the "dense-shallow-dense" doping mode, the potential at the middle position of the first surface presents a local "convex" region in an opposite direction, and carriers at the middle position may flow to two sides under action of an applied electric field, which helps smoothly extract the electrons on the first surface of the substrate in a reset process, and makes it easier to reset the pixel structure.

In some possible embodiments, as shown in FIG. 9, the first doped region 2021 and the second doped region 2022 are symmetric with respect to the centerline O-O of the pixel structure 2003, and the third doped region 2023 is symmetric with respect to the centerline O-O of the pixel structure 2003. In this way, when the first left modulation gate PGA and the first right modulation gate PGB are subject to complementary modulation, the carriers in the substrate have a same capability to enter the first carrier storage region FDA and the second carrier storage region FDB.

A length of the carrier collection region 202 is not limited in this embodiment of this application.

In an implementation of this application, as shown in FIG. 7b, the length of the carrier collection region 202 is equal to a length of the substrate 201 in a direction perpendicular to the first surface 2011. The length of the carrier collection region 202 may be a distance that the carrier collection region 202 extends from the first surface into the substrate along a Y axis.

Next, referring to FIG. 7b, the carrier collection region 202 extends longitudinally through the substrate 201, and the PN junction depletion region 203 is located on the substrate on the two sides of the carrier collection region 202.

In this way, a PN junction depletion region may be formed on the substrate on the two sides of the carrier collection region, so that carriers in the substrate on the two sides of the carrier collection region flow into the carrier collection region under action of an electric field of the PN junction depletion region, thereby improving modulation and demodulation efficiency of the pixel structure.

In another implementation of this application, the length of the carrier collection region 202 is less than the length of the substrate 201 in the direction perpendicular to the first surface 2011.

As shown in FIG. 11, the substrate 201 forms a U-shaped doped region, and the carrier collection region 202 is located within the U-shaped doped region 203, and an opening of the U-shaped doped region faces the first surface 2011 of the doped structure.

A U-shaped PN junction depletion region 203 is formed where the carrier collection region 202 is adjacent to the U-shaped doped region, and carriers in the U-shaped doped region flow from the U-shaped doped region to the carrier collection region under action of the U-shaped PN junction depletion region 203.

A person skilled in the art may select proper lengths of the carrier collection region 202 as required, which all fall within the protection scope of this application.

Quantities of first modulation gates and second modulation gates, and position relationships between the carrier collection region 202 and the modulation gates are not limited in this embodiment of this application.

The first carrier storage region FDA may be close to the at least one first modulation gate and far from the at least one second modulation gate, and the second carrier storage region FDB may be close to the at least one second modulation gate and far from the at least one first modulation gate.

The at least one first modulation gate and the at least one second modulation gate are disposed on the first surface along the first direction, and the at least one first modulation gate includes a first end that is the closest to the first carrier storage region FDA, and a second end that is the farthest from the first carrier storage region FDB.

Similarly, the at least one second modulation gate includes a first end that is closest to the second carrier storage region FDB and a second end that is farthest from the second carrier storage region FDB.

The first doped region is located between the first end and the second end of the at least one first modulation gate in the first direction, and the second doped region is located between the first end and the second end of the at least one second modulation gate in the first direction.

In an implementation of this application, there are one first modulation gate and one second modulation gate, and the first modulation gate and the second modulation gate are subject to complementary modulation.

As shown in FIG. 7a, the first modulation gate includes a first left modulation gate PGA, the second modulation gate includes a first right modulation gate PGB, and the first left modulation gate PGA and the first right modulation gate PGB are sequentially disposed on the first surface 2011 along the first direction. The carrier collection region is located below the first left modulation gate PGA and the first right modulation gate PGB, so that carriers in the carrier collection region may enter the first left modulation gate PGA or the first right modulation gate PGB through the first surface of the substrate.

In some possible embodiments, the carrier collection region 202 uses a single doping concentration.

The first left modulation gate PGA and the first right modulation gate PGB each include a first end and a second end that are opposite to each other. The first end of the first left modulation gate PGA is close to the first carrier storage region FDA, and the second end of the first left modulation gate PGA is far from the first carrier storage region FDA. The first end of the first right modulation gate PGB is close to the second carrier storage region FDB, and the second end of the first right modulation gate PGB is far from the second carrier storage region FDB. The second end of the first left modulation gate PGA is opposite to the second end of the first right modulation gate PGB.

The first end of the at least one first modulation gate is the first end of the first left modulation gate PGA, and the second end of the at least one first modulation gate is the second end of the first left modulation gate PGA.

The first end of the at least one second modulation gate is the first end of the first right modulation gate PGB, and the second end of the at least one second modulation gate is the second end of the first right modulation gate PGB.

The carrier collection region 202 is in contact with the at least one first modulation gate and the at least one second modulation gate on the first surface 2011, which means, for example, the carrier collection region 202 is in contact with each first modulation gate and each second modulation gate on the first surface.

A first interface of the carrier collection region 202 may be located between the first end and the second end of the first left modulation gate PGA. The first interface of the carrier collection region 202 is close to the first carrier storage region FDA.

In this way, the carrier collection region 202 can be in contact with the first left modulation gate PGA on the first surface 2011, and a distance for regulating carriers entering the first left modulation gate PGA can be reserved between the first carrier storage region FDA and the first interface of the carrier collection region, so that the carriers entering the first left modulation gate PGA flow to the first carrier storage region FDA under modulation of the first left modulation gate PGA.

A second interface of the carrier collection region 202 may be located between the first end and the second end of the first right modulation gate PGB. The second interface of the carrier collection region 202 is close to the second carrier storage region FDB.

In this way, the carrier collection region 202 can be in contact with the first right modulation gate PGB on the first surface 2011, and a distance for regulating carriers entering the first right modulation gate PGB can be reserved between the second carrier storage region FDB and the second interface of the carrier collection region, so that the carriers entering the first right modulation gate PGB flow to the second carrier storage region FDB under modulation of the first right modulation gate PGB.

In some other possible embodiments of this application, the carrier collection region 202 presents "dense-shallow-dense" doping distribution in the first direction. As shown in FIG. 9, the carrier collection region 202 includes a first doped region 2021, a second doped region 2022, and a third doped region 2023.

A first interface of the first doped region 2021 may be not beyond the first end of the first left modulation gate PGA, and the first interface of the first doped region 2021 is close to the first carrier storage region FDA.

In this way, the first doped region 2021 can be in contact with the first left modulation gate PGA on the first surface 2011, and a distance for regulating carriers entering the first left modulation gate PGA can be reserved between the first carrier storage region FDA and the first interface of the first doped region 2021, so that the carriers entering the first left modulation gate PGA flow to the first carrier storage region FDA under modulation of the first left modulation gate PGA.

A first interface of the second doped region 2022 may be not beyond the first end of the first right modulation gate PGB, and the first interface of the second doped region 2022 is close to the second carrier storage region FDB.

In this way, the second doped region 2022 can be in contact with the first right modulation gate PGB on the first surface, and a distance for regulating carriers entering the first right modulation gate PGB can be reserved between the second carrier storage region FDB and the first interface of the second doped region 2022, so that the carriers entering the first right modulation gate PGB flow to the second carrier storage region FDB under modulation of the first right modulation gate PGB.

A second interface of the first doped region 2021 may be not beyond the second end of the first left modulation gate PGA, and the second interface of the first doped region 2021 is an interface between the second doped region 2022 and the third doped region 2023.

In this way, the third doped region 2023 located between the first doped region 2021 and the second doped region 2022 can be in contact with the first left modulation gate PGA on the first surface, carriers in the third doped region 2023 can enter the first left modulation gate PGA through the first surface, and a distance for regulating carriers entering the first left modulation gate PGA is reserved, so that the carriers entering the first left modulation gate PGA flow to the first carrier storage region FDA under modulation of the first left modulation gate PGA.

A second interface of the second doped region 2022 may be not beyond the second end of the first right modulation gate PGB, and the second interface of the second doped region 2022 is an interface between the second doped region 2022 and the third doped region 2023.

In this way, the third doped region 2023 located between the first doped region 2021 and the second doped region 2022 can be in contact with the first right modulation gate PGB on the first surface, carriers in the third doped region 2023 can enter the first right modulation gate PGB through the first surface, and a distance for regulating carriers entering the first right modulation gate PGB is reserved, so that the carriers entering the first right modulation gate PGB flow to the second carrier storage region FDB under modulation of the first right modulation gate PGB.

In another implementation of this application, there are a plurality of first modulation gates and a plurality of second modulation gates. For example, as shown in figures, the first modulation gate includes a first left modulation gate TGA and a second left modulation gate PGA connected in series. The second modulation gate includes a first right modulation gate TGB and a second right modulation gate PGB connected in series. The first left modulation gate TGA and the first right modulation gate TGB are subject to complementary modulation, and the second left modulation gate PGA and the second right modulation gate PGB are subject to complementary modulation. That is, when the first left modulation gate PGA is turned on, the first right modulation gate PGB is turned off, and when the first right modulation gate PGB is turned on, the first left modulation gate PGA is turned off. When the first right modulation gate PGA is turned on, the second right modulation gate PGB is turned off, and when the second right modulation gate PGB is turned on, the first right modulation gate PGA is turned off.

For example, in a time period A, the first left modulation gate TGA and the second left modulation gate PGA are turned on, and the first right modulation gate TGB and the second right modulation gate PGB are turned off.

In another time period other than the time period A, for example, in a time period B, the first right modulation gate TGB and the second right modulation gate PGB are turned on, and the first left modulation gate TGA and the second left modulation gate PGA are turned off.

It should be noted that the "TG" is an English abbreviation of a turbo gate (accelerated modulation diode).

The first left modulation gate TGA, the second left modulation gate PGA, the second right modulation gate PGB, and the first right modulation gate TGB are sequentially disposed on the first surface 2011 of the substrate 201 along the first direction, and the first left modulation gate TGA, the second left modulation gate PGA, the first right modulation gate TGB, and the second right modulation gate PGB are all in contact with the carrier collection region 202 on the first surface 2011, so that carriers in the carrier collection region can enter the first left modulation gate TGA, the second left modulation gate PGA, the first right modulation gate TGB, and the second right modulation gate PGB through the first surface.

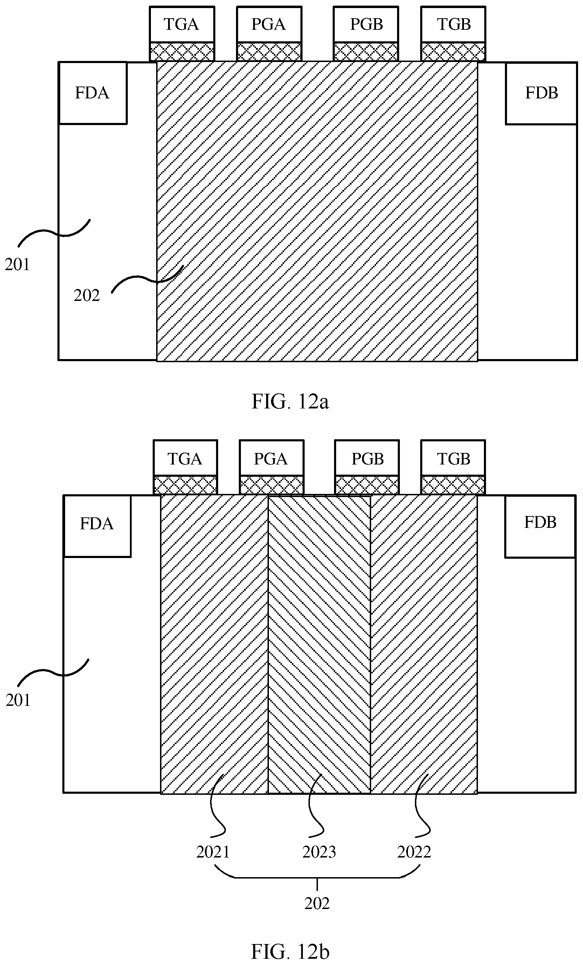

In some possible embodiments, as shown in FIG. 12a, the carrier collection region 202 uses a single doping concentration.

The first left modulation gate TGA, the second left modulation gate PGA, the first right modulation gate TGB, and the second right modulation gate PGB in FIG. 12a each include a first end and a second end that are opposite to each other. The first end of the first left modulation gate TGA is close to the first carrier storage region FDA, the second end of the first left modulation gate TGA is far from the first carrier storage region FDA, and the second end of the first left modulation gate TGA is opposite to the first end of the second left modulation gate PGA. The first end of the first right modulation gate TGB is close to the second carrier storage region FDB, the second end of the first right modulation gate TGB is far from the second carrier storage region FDB, and the second end of the first right modulation gate TGB is opposite to the first end of the second right modulation gate PGB. The second end of the second left modulation gate PGA is close to the second end of the second right modulation gate PGB.

The first end of the at least one first modulation gate is the first end of the first left modulation gate TGA, and the second end of the at least one first modulation gate is the second end of the second left modulation gate PGA.

The first end of the at least one second modulation gate is the first end of the first right modulation gate TGB, and the second end of the at least one second modulation gate is the second end of the second right modulation gate PGB.

The first interface of the carrier collection region 202 may be located between the first end and the second end of the first left modulation gate TGA.

In this way, the carrier collection region 202 can be in contact with the first left modulation gate TGA on the first surface 2011, and a distance for regulating carriers entering the first left modulation gate TGA can be reserved between the first carrier storage region FDA and the first interface of the carrier collection region, so that the carriers entering the first left modulation gate TGA flow to the first carrier storage region FDA.

The second interface of the carrier collection region 202 may be located between the first end and the second end of the first right modulation gate TGB.

In this way, the carrier collection region 202 can be in contact with the first right modulation gate TGB on the first surface 2011, and a distance for regulating carriers entering the first right modulation gate TGB can be reserved between the second carrier storage region FDB and the second interface of the carrier collection region, so that the carriers entering the first right modulation gate TGB flow to the second carrier storage region FDB.

In some other possible embodiments of this application, the carrier collection region 202 presents "dense-shallow-dense" doping distribution in the first direction. As shown in FIG. 12b, the carrier collection region 202 includes a first doped region 2021, a second doped region 2022, and a third doped region 2023 sequentially arranged along the first direction.

A first interface of the first doped region 2021 may be not beyond the first end of the first left modulation gate TGA.

In this way, the first doped region 2021 can be in contact with the first left modulation gate TGA on the first surface, and a distance for regulating carriers entering the first left modulation gate TGA can be reserved between the first carrier storage region FDA and the first interface of the first doped region 2021, so that the carriers entering the first left modulation gate TGA flow to the first carrier storage region FDA under modulation of the first left modulation gate TGA.

A first interface of the second doped region 2022 may be not beyond the first end of the first right modulation gate TGB.

In this way, the second doped region 2022 can be in contact with the first right modulation gate TGB on the first surface, and a distance for regulating carriers entering the first right modulation gate TGB can be reserved between the second carrier storage region FDB and the first interface of the second doped region 2022, so that the carriers entering the first right modulation gate TGB flow to the second carrier storage region FDB under modulation of the first right modulation gate TGB.

A second interface of the first doped region 2021 may be not beyond the second end of the second left modulation gate PGA.

In this way the third doped region 2023 located between the first doped region 2021 and the second doped region 2022 can be in contact with the second left modulation gate PGA on the first surface, carriers in the third doped region 2023 can enter the second left modulation gate PGA through the first surface, and a distance for regulating carriers entering the second right modulation gate PGB is reserved, so that the carriers entering the second right modulation gate PGB flow to the first carrier storage region FDA.

A second interface of the second doped region 2022 may be not beyond the second end of the second right modulation gate PGB.

In this way, the third doped region 2023 located between the first doped region 2021 and the second doped region 2022 can be in contact with the second right modulation gate PGB on the first surface, carriers in the third doped region 2023 can enter the second right modulation gate PGB through the first surface, and a distance for regulating carriers entering the second right modulation gate PGB is reserved, so that the carriers entering the second right modulation gate PGB flow to the second carrier storage region FDB.

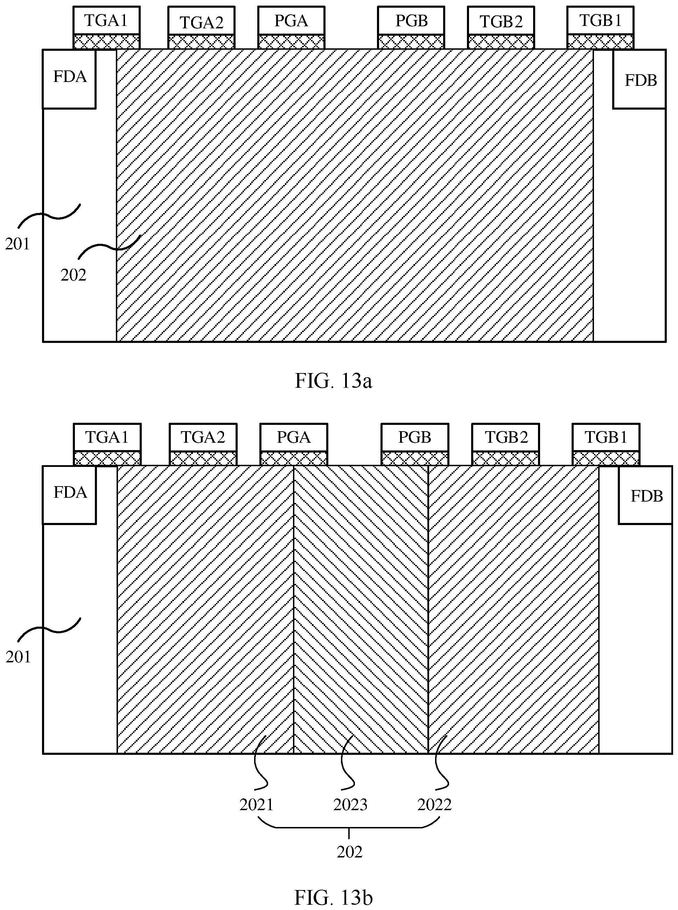

For another example, as shown in FIG. 13a, there are three first modulation gates: a first left modulation gate TGA1, a second left modulation gate TGA2, and a third left modulation gate PGA, and there are three second modulation gates: a first right modulation gate TGB1, a second right modulation gate TGB2, and a third right modulation gate PGB.

The first left modulation gate TGA1 and the first right modulation gate TGB1 are subject to complementary modulation, the second left modulation gate TGA2 and the second right modulation gate TGB2 are subject to complementary modulation, and the third left modulation gate PGA and the third right modulation gate PGB are subject to complementary modulation. That is, when the first left modulation gate TGA1 is turned on, the first right modulation gate TGB1 is turned off, and when the first right modulation gate TGB1 is turned on, the first left modulation gate TGA1 is turned off. When the second left modulation gate TGA2 is turned on, the second right modulation gate TGB2 is turned off, and when the second right modulation gate TGB2 is turned on, the second left modulation gate TGA2 is turned off. When the third left modulation gate PGA is turned on, the third right modulation gate PGB is turned off, and when the third right modulation gate PGB is turned on, the third left modulation gate PGA is turned off.

For example, in a time period A, the first left modulation gate TGA1, the second left modulation gate TGA2, and the third left modulation gate PGA are turned on, and the first right modulation gate TGB1, the second right modulation gate TGB2, and the third right modulation gate PGB are turned off.

In another time period other than the time period A, for example, in a time period B, the first right modulation gate TGB1, the second right modulation gate TGB2, and the third right modulation gate PGB are turned on, the first left modulation gate TGA1, the second left modulation gate TGA2, and the third left modulation gate PGA are turned off.

The first left modulation gate TGA1, the second left modulation gate TGA2, the third left modulation gate PGA, the third right modulation gate PGB, the second right modulation gate TGB2, and the first right modulation gate TGB1 may be sequentially disposed on the first surface 2011 of the substrate 201 along the first direction. The first left modulation gate TGA1, the second left modulation gate TGA2, the third left modulation gate PGA, the third right modulation gate PGB, the second right modulation gate TGB2, and the first right modulation gate TGB1 are all in contact with the carrier collection region 202 on the first surface 2011.

As shown in FIG. 13a, the first left modulation gate TGA1, the second left modulation gate TGA2, the third left modulation gate PGA, the third right modulation gate PGB, the second right modulation gate TGB2, and the first right modulation gate TGB1 each include a first end and a second end that are opposite to each other. The first end of the first left modulation gate TGA1 is close to the first carrier storage region FDA, the second end of the first left modulation gate TGA1 is opposite to the first end of the second left modulation gate TGA2, and the second end of the second left modulation gate TGA2 is opposite to the first end of the third left modulation gate PGA. The second end of the third left modulation gate PGA is opposite to the second end of the third right modulation gate PGB. The first end of the first right modulation gate TGB1 is close to the second carrier storage region FDB, the second end of the first right modulation gate TGB1 is opposite to the first end of the second right modulation gate TGB2, and the second end of the second right modulation gate TGB2 is opposite to the first end of the third right modulation gate PGB.

The first end of the at least one first modulation gate is the first end of the first left modulation gate TGA1, and the second end of the at least one first modulation gate is the second end of the third left modulation gate PGA.

The first end of the at least one second modulation gate is the first end of the first right modulation gate TGB1, and the second end of the at least one second modulation gate is the second end of the third right modulation gate PGB.

The carrier collection region 202 in FIG. 13a may use a single doping concentration.

The first interface of the carrier collection region 202 may be located between the first end and the second end of the first left modulation gate TGA1.

In this way, the carrier collection region 202 can be in contact with the first left modulation gate TGA1 on the first surface 2011, and a distance for regulating carriers entering the first left modulation gate TGA1 can be reserved between the first carrier storage region FDA and the first interface of the carrier collection region, so that the carriers entering the first left modulation gate TGA1 flow to the first carrier storage region FDA.

The second interface of the carrier collection region 202 may be located between the first end and the second end of the first right modulation gate TGB1.

In this way, the carrier collection region 202 can be in contact with the first right modulation gate TGB 1 on the first surface 2011, and a distance for regulating carriers entering the first right modulation gate TGB1 can be reserved between the second carrier storage region FDB and the second interface of the carrier collection region, so that the carriers entering the first right modulation gate TGB1 flow to the second carrier storage region FDB.

In some other possible embodiments of this application, the carrier collection region 202 presents "dense-shallow-dense" doping distribution in the first direction. As shown in FIG. 13b, the carrier collection region 202 includes a first doped region 2021, a second doped region 2022, and a third doped region 2023 sequentially arranged along the first direction.

A first interface of the first doped region 2021 may be not beyond the first end of the first left modulation gate TGA1.

In this way, the first doped region 2021 can be in contact with the first left modulation gate TGA1 on the first surface, and a distance for regulating carriers entering the first left modulation gate TGA1 can be reserved between the first carrier storage region FDA and the first interface of the first doped region 2021, so that the carriers entering the first left modulation gate TGA1 flow to the first carrier storage region FDA under modulation of the first left modulation gate TGA1.

A first interface of the second doped region 2022 may be not beyond the first end of the first right modulation gate TGB1.

In this way, the second doped region 2022 can be in contact with the first right modulation gate TGB1 on the first surface, and a distance for regulating carriers entering the first right modulation gate TGB1 can be reserved between the second carrier storage region FDB and the first interface of the second doped region 2022, so that the carriers entering the first right modulation gate TGB1 flow to the second carrier storage region FDB under modulation of the first right modulation gate TGB1.

A second interface of the first doped region 2021 may be not beyond the second end of the third left modulation gate PGA.

In this way, the third doped region 2023 located between the first doped region 2021 and the second doped region 2022 can be in contact with the third left modulation gate PGA on the first surface, carriers in the third doped region 2023 can enter the third left modulation gate PGA through the first surface, and a distance for regulating carrier entering the third left modulation gate PGA is reserved, so that the carriers entering the third left modulation gate PGA flow to the first carrier storage region FDA.

A second interface of the second doped region 2022 may be not beyond the second end of the third right modulation gate PGB.

In this way, the third doped region 2023 located between the first doped region 2021 and the second doped region 2022 may be in contact with the third right modulation gate PGB on the first surface, carriers in the third doped region 2023 can enter the third right modulation gate PGB through the first surface, and a distance for regulating carriers entering the third right modulation gate PGB is reserved, so that the carriers entering the third right modulation gate PGB flow to the second carrier storage region FDB.

In addition, a first gate is disposed between the at least one first modulation gate and the first carrier storage region FDA, and a second gate is disposed between the at least one second modulation gate and the second carrier storage region FDB.

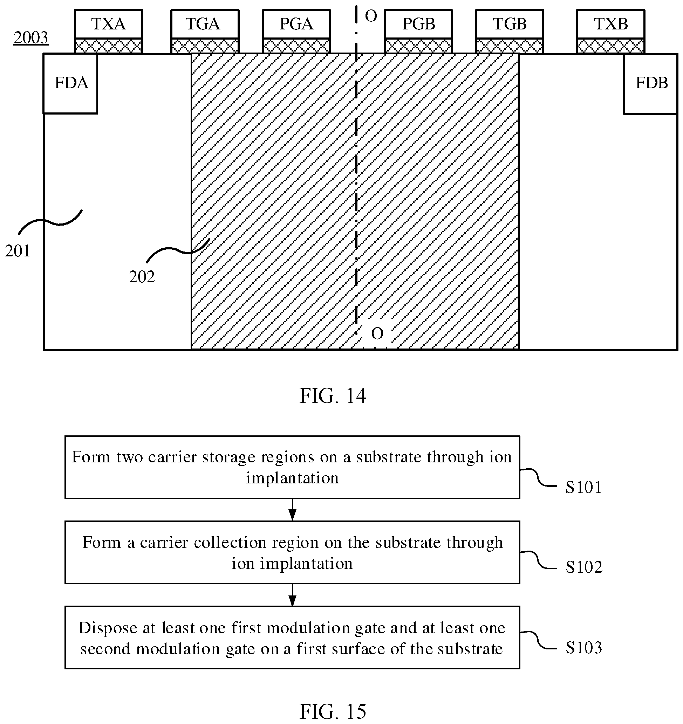

As shown in FIG. 14, there are two first modulation gates: a first left modulation gate TGA and a second left modulation gate PGA connected in series. There are two second modulation gates: a first right modulation gate TGB and a second right modulation gate PGB connected in series. The first gate is TXA, and the second gate is TXB.

The first gate TXA and the second gate TXB may be symmetric with respect to the centerline O-O of the pixel structure 2003.

In this way, the carriers in the substrate have a same capability to enter the first carrier storage region FDA and the second carrier storage region FDB.

One end of the at least one first modulation gate is coupled to the carrier collection region 202, the other end is connected to the first carrier storage region FDA by using the first gate TXA, and the carriers in the carrier collection region 202 may reach the FDA through the first modulation gate and the first gate TXA sequentially.

One end of the at least one second modulation gate is coupled to the carrier collection region 202, the other end is coupled to the second carrier storage region FDB by using the second gate TXB, and the carriers in the carrier collection region 202 may reach the FDB through the second modulation gate and the second gate TXB sequentially.

The TXA and the TXB are configured to receive direct current modulation signals. In this case, the first gate TXA and the second gate TXB may always be in an on state in the time period A and the time period B.

In this way, the direct current signal received by the first gate TXA may shield impact of an alternating current signal received by the at least one first modulation gate on the first carrier storage region FDA.

Similarly, the direct current signal received by the second gate TXB may shield impact of an alternating current signal received by the at least one second modulation gate on the second carrier storage region FDB.

Moreover, by adjusting a voltage value of the first gate, steepness of potential distribution between the first carrier storage region FDA and the first modulation gate can be increased, thereby helping the carriers in the substrate to flow into the first carrier storage region FDA. By adjusting a voltage value of the second gate, steepness of potential distribution between the second carrier storage region FDB and the second modulation gate can be increased, thereby helping the carriers in the substrate to flow into the second carrier storage region FDB.

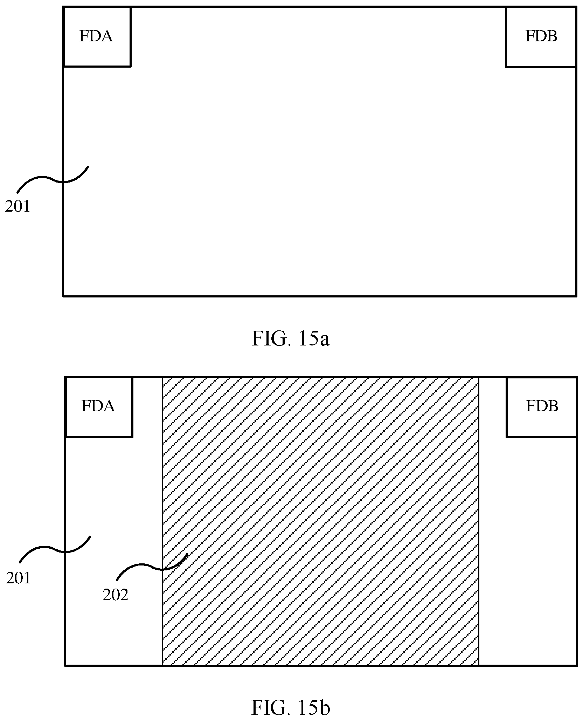

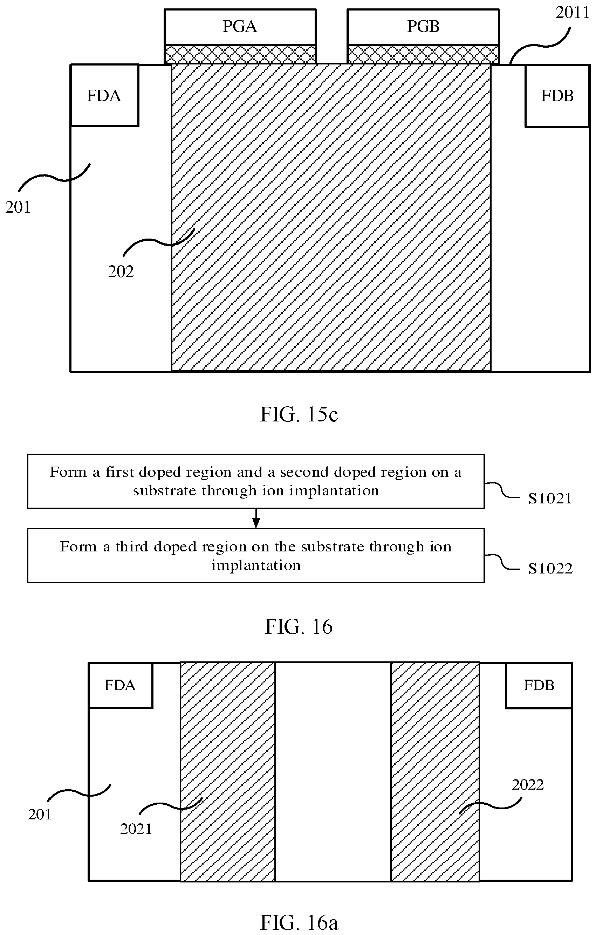

An embodiment of this application provides a method for manufacturing a pixel structure. FIG. 15 is a flowchart of a method for manufacturing a pixel structure according to an embodiment of this application. As shown in FIG. 15, the method includes the following steps.

S101. Form two carrier storage regions on a substrate 201 through ion implantation, as shown in FIG. 15a.

The first surface may be any surface of the substrate 201. The two carrier storage regions are respectively located on two sides of the substrate 201 in a first direction. The first direction is a direction parallel to the first surface 2011.

Before the ion implantation, a mask may be disposed on the first surface 1011 of the substrate. The mask may be disposed at a middle position of the first surface 1011, to reserve regions for the ion implantation on two sides of the first surface 1011. The ion implantation may be performed in the regions, to change doping types of the regions, and obtain the carrier storage regions.

After the ion implantation is completed, the mask may be removed.

The doping types of the two carrier storage regions are opposite to a doping type of the substrate 201.

For example, the two carrier storage regions use N-type doping and the substrate uses P-type doping, or the two carrier storage regions use P-type doping and the substrate uses N-type doping.

S102. Form a carrier collection region 202 on the substrate 201 through ion implantation, as shown in FIG. 15b.

The carrier collection region 202 is located between the two carrier storage regions in the first direction, and a doping concentration of the carrier collection region 202 is greater than a doping concentration of the substrate 201, the carrier collection region 202 and the two carrier storage regions have a same doping type, and the carrier collection region 202 and the substrate 201 have opposite doping types.

Before the ion implantation, a mask may be disposed on each of the two sides of the first surface 1011 of the substrate, to reserve a region for the ion implantation at the middle position of the first surface 1011. The ion implantation may be performed in the region, to change a doping type of the region, and obtain the carrier collection region 202.

After the ion implantation is completed, the mask may be removed.

A depth of the ion implantation may be adjusted by controlling ion energy, to adjust a length of the carrier collection region. In an implementation of this application, in a direction perpendicular to the first surface, a length of the carrier collection region is less than a length of the substrate. In another implementation of this application, the length of the carrier collection region is equal to the length of the substrate.

In this way, a carrier collection region 202 with a single concentration may be formed.

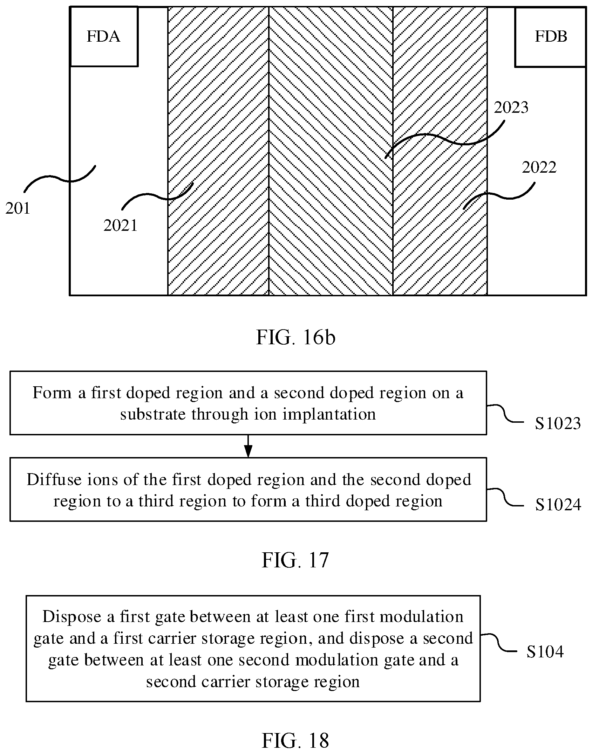

As shown in FIG. 16, in an implementation of this application, step S102 of forming a carrier collection region 202 on the substrate 201 through ion implantation may include the following steps.

S1021. Form a first doped region 2021 and a second doped region 2022 on the substrate 201 through ion implantation, as shown in FIG. 16a.

The first doped region 2021 and the second doped region 2022 are respectively located on two sides of the carrier collection region 202 in the first direction.

Before the ion implantation, three masks may be disposed on the first surface 1011 of the substrate, to reserve regions for the ion implantation on the first surface 1011. The ion implantation may be performed in the regions, to change doping types of the regions, and obtain the first doped region 2021 and the second doped region 2022.

After the ion implantation is completed, the masks may be removed.

S1022. Form a third doped region 2023 on the substrate 201 through ion implantation, as shown in FIG. 16b.

Doping concentrations of the first doped region 2021 and the second doped region 2022 are both greater than a doping concentration of the third doped region 2023, and the third doped region 2023 is located between the first doped region 2021 and the second doped region 2022.

Before the ion implantation, two masks may be disposed on the first surface 1011 of the substrate, and a region for the ion implantation is reserved on the first surface 1011. The ion implantation may be performed in the region, to change a doping type of the region, and obtain the third doped region 2023.

After the ion implantation is completed, the masks may be removed.

In this way, carrier collection regions with "dense-shallow-dense" distribution of doping concentrations in the first direction may be obtained.

As shown in FIG. 17, in another implementation of this application, step S102 of forming a carrier collection region 202 on the substrate 201 through ion implantation may include the following steps.

S1023. Form a first doped region 2021 and a second doped region 2022 on the substrate 201 through ion implantation, as shown in FIG. 16a.

The first doped region 2021 and the second doped region 2022 are respectively located on two sides of the carrier collection region 202 in the first direction.

For a doping method for the first doped region and the second doped region, refer to S1021. Details are not described herein again.

S1024. Next, diffuse ions of the first doped region 2021 and the second doped region 2022 to a third region to form a third doped region 2023, as shown in FIG. 16b.

Doping concentrations of the first doped region 2021 and the second doped region 2022 are both greater than a doping concentration of the third doped region 2023, and the third doped region 2023 is located between the first doped region 2021 and the second doped region 2022.

In this way, compared with step S1022, neither a mask nor ion implantation is required, thereby helping simplify a manufacturing process.

S103. Dispose at least one first modulation gate and at least one second modulation gate on the first surface 2011 of the substrate 201, as shown in FIG. 15c.

As shown in FIG. 15, the first modulation gate includes a first left modulation gate PGA, and the second modulation gate includes a first right modulation gate PGB.

The first left modulation gate PGA and the first right modulation gate PGB are subject to complementary modulation, and the carrier collection region 202 is in contact with the first left modulation gate PGA and the first right modulation gate PGB on the first surface 2011.

In an implementation of this application, the carrier collection region 202 uses a single doping concentration.

The disposing at least one first modulation gate and at least one second modulation gate on the first surface 2011 of the substrate 201 includes:

disposing the at least one first modulation gate and the at least one second modulation gate on the first surface 2011 along the first direction, so that the carrier collection region 202 is located between a first end of the at least one first modulation gate and a first end of the at least one second modulation gate in the first direction.

In another implementation of this application, the carrier collection region 202 includes the first doped region 2021, the second doped region 2022, and the third doped region 2023.

The disposing at least one first modulation gate and at least one second modulation gate on the first surface 2011 of the substrate 201 includes:

disposing the at least one first modulation gate and the at least one second modulation gate on the first surface 2011 along the first direction, so that the first doped region 2021 is located between a first end and a second end of the at least one first modulation gate in the first direction, and the second doped region 2022 is located between a first end and a second end of the at least one second modulation gate in the first direction.

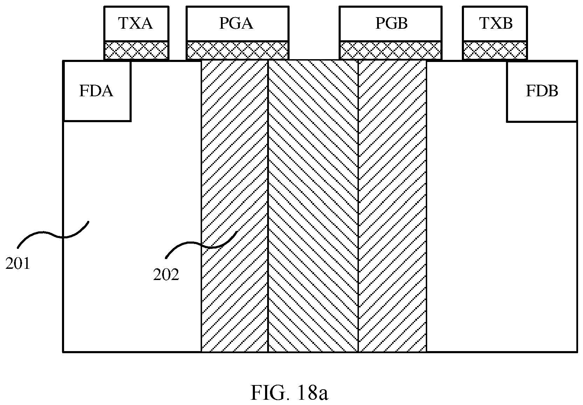

As shown in FIG. 18, in another implementation of this application, the method further includes the following step.

S104. Dispose a first gate between the at least one first modulation gate and the first carrier storage region FDA, and dispose a second gate between the at least one second modulation gate and the second carrier storage region FDB, as shown in FIG. 18a.

The first modulation gate and the second modulation gate are configured to receive alternating current modulation signals, and the first gate and the second gate are configured to receive direct current modulation signals.

The foregoing description is merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A pixel structure, wherein the pixel structure comprises:

   a modulation gate group, wherein the modulation gate group comprises:

      at least one first modulation gate sequentially disposed on a first surface of a substrate; and

at least one second modulation gate sequentially disposed on the first surface, wherein the at least one second modulation gate and the at least one first modulation gate are subject to complementary modulation; and

the substrate, comprising:

at least two carrier storage regions, wherein the at least two carrier storage regions comprise a first carrier storage region and a second carrier storage region respectively located on two sides of the substrate in a first direction, and the first direction is a direction parallel to the first surface; and
a carrier collection region, located between the at least two carrier storage regions in the first direction, and in contact with the modulation gate group on the first surface, wherein a doping concentration of the carrier collection region is greater than a doping concentration of the substrate, the carrier collection region and the at least two carrier storage regions have a same doping type, and the carrier collection region and the substrate have opposite doping types.

2. The pixel structure according to claim 1, wherein the carrier collection region comprises:

   a first doped region and a second doped region respectively located on two sides of the carrier collection region in the first direction; and
   a third doped region, located between the first doped region and the second doped region, wherein doping concentrations of the first doped region and the second doped region are both greater than a doping concentration of the third doped region.

3. The pixel structure according to claim 2, wherein the first carrier storage region is close to the at least one first modulation gate and far from the at least one second modulation gate, and the second carrier storage region is close to the at least one second modulation gate and far from the at least one first modulation gate;

   the at least one first modulation gate and the at least one second modulation gate are disposed on the first surface along the first direction, the at least one first modulation gate comprises a first end that is the closest to the first carrier storage region and a second end that is the farthest from the first carrier storage region, and the at least one second modulation gate comprises a first end that is the closest to the second carrier storage region and a second end that is the farthest from the second carrier storage region; and the first doped region is located between the first end and the second end of the at least one first modulation gate in the first direction, and the second doped region is located between the first end and the second end of the at least one second modulation gate in the first direction.

4. The pixel structure according to claim 2 or 3, wherein the doping concentration of the first doped region is 10 to 100 times the doping concentration of the third doped region, and the doping concentration of the second doped region is 10 to 100 times the doping concentration of the third doped region.

5. The pixel structure according to any one of claims 2 to 4, wherein the first doped region and the second doped region are symmetrically disposed relative to a first axis, the third doped region is symmetric relative to the first axis, the first axis is perpendicular to the first surface.

6. The pixel structure according to claim 1, wherein the at least one first modulation gate and the at least one second modulation gate are disposed on the first surface along the first direction, the first carrier storage region is close to the at least one first modulation gate and far from the at least one second modulation gate, and the second carrier storage region is close to the at least one second modulation gate and far from the at least one first modulation gate;

the at least one first modulation gate comprises a first end that is the closest to the first carrier storage region and a second end that is the farthest from the first carrier storage region, and the at least one second modulation gate comprises a first end that is the closest to the second carrier storage region and a second end that is the farthest from the second carrier storage region; and the carrier collection region is located between the first end of the at least one first modulation gate and the first end of the at least one second modulation gate in the first direction.

7. The pixel structure according to any one of claims 1 to 6, wherein in a direction perpendicular to the first surface, a length of the carrier collection region is equal to a length of the substrate.

8. The pixel structure according to any one of claims 1 to 6, wherein in a direction perpendicular to the first surface, a length of the carrier collection region is less than a length of the substrate.

9. The pixel structure according to any one of claims 1 to 8, wherein the carrier storage regions comprise a first carrier storage region close to the at least one first modulation gate, and a second carrier storage region close to the at least one second modulation gate;

a first gate is disposed between the at least one first modulation gate and the first carrier storage region, and a second gate is disposed between the at least one second modulation gate and the second carrier storage region; and the at least one first modulation gate and the at least one second modulation gate are configured to receive alternating current modulation signals, and the first gate and the second gate are configured to receive direct current modulation signals.

10. The pixel structure according to any one of claims 1 to 9, wherein the doping concentration of the carrier collection region is 1000 to 10000 times the doping concentration of the substrate.

11. The pixel structure according to any one of claims 1 to 10, wherein the carrier collection region uses P-type doping, and the substrate uses N-type doping; or the carrier collection region uses N-type doping, and the substrate uses P-type doping.

12. The pixel structure according to any one of claims 1 to 11, wherein the modulation gate group further comprises:

at least one third modulation gate sequentially disposed on the first surface of the substrate; and at least one fourth modulation gate sequentially disposed on the first surface, wherein the at least one first modulation gate, the at least one second modulation gate, the at least one third modulation gate, and the at least one fourth modulation gate are subject to complementary modulation, wherein the first modulation gate and the second modulation gate are symmetric with respect to a center of the first surface, and the third modulation gate and the fourth modulation gate are symmetric with respect to the center of the first surface;
the at least two carrier storage regions further comprise a third carrier storage region and a fourth carrier storage region respectively located on two sides of the substrate in a second direction, the second direction is parallel to the first surface, and the second direction is perpendicular to the first direction; and

the carrier collection region is located between the third carrier storage region and the fourth carrier storage region in the second direction.

13. A method for manufacturing a pixel structure, wherein the method comprises:

   forming at least two carrier storage regions on a substrate through ion implantation, wherein the at least two carrier storage regions comprise a first carrier storage region and a second carrier storage region respectively located on two sides of the substrate in a first direction, and the first direction is a direction parallel to a first surface of the substrate;
   forming a carrier collection region on the substrate through ion implantation, wherein the carrier collection region is located between the first carrier storage region and the second carrier storage region in the first direction, a doping concentration of the carrier collection region is greater than a doping concentration of the substrate, the carrier collection region and the at least two carrier storage regions have a same doping type, and the carrier collection region and the substrate have opposite doping types; and
   disposing a modulation gate group on the first surface of the substrate, wherein the modulation gate group comprises at least one first modulation gate and at least one second modulation gate, the at least one second modulation gate and the at least one first modulation gate are subject to complementary modulation, and the carrier collection region is in contact with the modulation gate group on the first surface.

14. The method for manufacturing a pixel structure according to claim 13, wherein the first carrier storage region is close to the at least one first modulation gate and far from the at least one second modulation gate, and the second carrier storage region is close to the at least one second modulation gate and far from the at least one first modulation gate;

   the at least one first modulation gate comprises a first end that is the closest to the first carrier storage region and a second end that is the farthest from the first carrier storage region, and the at least one second modulation gate comprises a first end that is the closest to the second carrier storage region and a second end that is the farthest from the second carrier storage region; and
   the disposing at least one first modulation gate and at least one second modulation gate on the first surface of the substrate comprises:
   disposing the at least one first modulation gate and the at least one second modulation gate on the first surface along the first direction, so that the carrier collection region is located between the first end of the at least one first modulation gate and the first end of the at least one second modulation gate in the first direction.

15. The method for manufacturing a pixel structure according to claim 13 or 14, wherein
the forming a carrier collection region on the substrate through ion implantation comprises:

   forming a first doped region and a second doped region on the substrate through ion implantation, wherein the first doped region and the second doped region are respectively located on two sides of the carrier collection region in the first direction; and
   forming a third doped region on the substrate through ion implantation, wherein doping concentrations of the first doped region and the second doped region are both greater than a doping concentration of the third doped region, and the third doped region is located between the first doped region and the second doped region.

16. The method for manufacturing a pixel structure according to claim 13 or 14, wherein
the forming a carrier collection region on the substrate through ion implantation comprises:

   forming a first doped region and a second doped region on the substrate through ion implantation, wherein the first doped region and the second doped region are respectively located on two sides of the carrier collection region in the first direction; and
   diffusing ions of the first doped region and the second doped region to a third region to form a third doped region, wherein doping concentrations of the first doped region and the second doped region are both greater than a doping concentration of the third doped region, and the third doped region is located between the first doped region and the second doped region.

17. The method for manufacturing a pixel structure according to claim 15 or 16, wherein the first carrier storage region is close to the at least one first modulation gate and far from the at least one second modulation gate, and the second carrier storage region is close to the at least one second modulation gate and far from the at least one first modulation gate;

   the at least one first modulation gate comprises a first end that is the closest to the first carrier storage region and a second end that is the farthest from the first carrier storage region, and

the at least one second modulation gate comprises a first end that is the closest to the second carrier storage region and a second end that is the farthest from the second carrier storage region; and

the disposing at least one first modulation gate and at least one second modulation gate on the first surface of the substrate comprises:

disposing the at least one first modulation gate and the at least one second modulation gate on the first surface along the first direction, so that the first doped region is located between the first end and the second end of the at least one first modulation gate in the first direction, and the second doped region is located between the first end and the second end of the at least one second modulation gate in the first direction.

18. The method for manufacturing a pixel structure according to any one of claims 15 to 17, wherein the doping concentration of the first doped region is 10 to 100 times the doping concentration of the third doped region, and the doping concentration of the second doped region is 10 to 100 times the doping concentration of the third doped region.

19. The method for manufacturing a pixel structure according to any one of claims 15 to 18, wherein the first doped region and the second doped region are symmetrically disposed relative to a first axis, the third doped region is symmetric relative to the first axis, the first axis is perpendicular to the first surface.

20. The method for manufacturing a pixel structure according to any one of claims 13 to 19, wherein in a direction perpendicular to the first surface, a length of the carrier collection region is less than or equal to a length of the substrate.

21. The method for manufacturing a pixel structure according to any one of claims 14 to 20, wherein the at least two carrier storage regions comprise a first carrier storage region close to the at least one first modulation gate, and a second carrier storage region close to the at least one second modulation gate, and the method further comprises:

disposing a first gate between the at least one first modulation gate and the first carrier storage region; and

disposing a second gate between the at least one second modulation gate and the second carrier storage region, wherein the first modulation gate and the second modulation gate are configured to receive alternating current modulation signals, and the first gate and the second gate are configured to receive direct current modulation signals.

22. The method for manufacturing a pixel structure according to any one of claims 13 to 21, wherein the doping concentration of the carrier collection region is 1000 to 10000 times the doping concentration of the substrate.

23. The method for manufacturing a pixel structure according to any one of claims 13 to 22, wherein the carrier collection region uses P-type doping, and the substrate uses N-type doping; or

the carrier collection region uses N-type doping, and the substrate uses P-type doping.

24. The method for manufacturing a pixel structure according to any one of claims 13 to 23, wherein the modulation gate group further comprises:

at least one third modulation gate sequentially disposed on the first surface of the substrate; and

at least one fourth modulation gate sequentially disposed on the first surface, wherein the at least one first modulation gate, the at least one second modulation gate, the at least one third modulation gate, and the at least one fourth modulation gate are subject to complementary modulation, wherein

the first modulation gate and the second modulation gate are symmetric with respect to a center of the first surface, and the third modulation gate and the fourth modulation gate are symmetric with respect to the center of the first surface;

the at least two carrier storage regions further comprise a third carrier storage region and a fourth carrier storage region respectively located on two sides of the substrate in a second direction, the second direction is parallel to the first surface, and the second direction is perpendicular to the first direction; and

the carrier collection region is located between the third carrier storage region and the fourth carrier storage region in the second direction.

FIG. 1

FIG. 2

FIG. 3

01

10

02

12

OP1
OP2

PCB

11

FIG. 4

10

| LCD | 101 |
| BLU | 102 |

FIG. 5

01

100

12:00
**Monday,
January 1**

FIG. 6a

10
100

S1
S2

FIG. 6b

100

2003
2001
200
2002

211

Control circuit

Readout circuit

Image processing circuit

210

212

FIG. 7

FIG. 7a

FIG. 7b

FIG. 7c

FIG. 7d

FIG. 8

FIG. 9

FIG. 10

FIG. 11

FIG. 12a

FIG. 12b

FIG. 13a

FIG. 13b

2003

| TXA | TGA | PGA | | O | PGB | TGB | TXB |

FDA

FDB

201

202

O

FIG. 14

| Form two carrier storage regions on a substrate through ion implantation |
|---|
S101

| Form a carrier collection region on the substrate through ion implantation |
|---|
S102

| Dispose at least one first modulation gate and at least one second modulation gate on a first surface of the substrate |
|---|
S103

FIG. 15

FIG. 15a

FIG. 15b

FIG. 15c

Form a first doped region and a second doped region on a substrate through ion implantation — S1021

Form a third doped region on the substrate through ion implantation — S1022

FIG. 16

FIG. 16a

FIG. 16b

| Form a first doped region and a second doped region on a substrate through ion implantation | |
|---|---|
| | S1023 |

| Diffuse ions of the first doped region and the second doped region to a third region to form a third doped region | |
|---|---|
| | S1024 |

FIG. 17

| Dispose a first gate between at least one first modulation gate and a first carrier storage region, and dispose a second gate between at least one second modulation gate and a second carrier storage region | |
|---|---|
| | S104 |

FIG. 18

| TXA | PGA | PGB | TXB |

| FDA | | | FDB |

201

202

FIG. 18a

## INTERNATIONAL SEARCH REPORT

International application No.

**PCT/CN2019/105235**

**A. CLASSIFICATION OF SUBJECT MATTER**

H01L 27/146(2006.01)i; G01B 11/14(2006.01)i; H01L 31/0224(2006.01)i

According to International Patent Classification (IPC) or to both national classification and IPC

**B. FIELDS SEARCHED**

Minimum documentation searched (classification system followed by classification symbols)

H01L; G01B

Documentation searched other than minimum documentation to the extent that such documents are included in the fields searched

Electronic data base consulted during the international search (name of data base and, where practicable, search terms used)

CNPAT, CNKI, WPI, EPODOC: 华为, TOF, 飞行时间, 衬底, 掺杂, 浓度, 栅极, 掺杂类型, 浮置扩散, time of flight, substrate, doping concentration, modulation gate, doping type, floating diffusion

**C. DOCUMENTS CONSIDERED TO BE RELEVANT**

| Category* | Citation of document, with indication, where appropriate, of the relevant passages | Relevant to claim No. |
|---|---|---|
| Y | CN 102376728 A (SAMSUNG ELECTRONICS CO., LTD.) 14 March 2012 (2012-03-14) description paragraphs 0074-0100, figures 3-6 | 1-24 |
| Y | CN 107958914 A (INFINEON TECHNOLOGIES AG et al.) 24 April 2018 (2018-04-24) description paragraphs 0032-0088, figures 1-3 | 1-24 |
| A | CN 109346553 A (XI'AN FEIXIN ELECTRONIC TECHNOLOGY CO., LTD.) 15 February 2019 (2019-02-15) entire document | 1-24 |
| A | US 2016005913 A1 (SENSL TECHNOLOGIES LTD.) 07 January 2016 (2016-01-07) entire document | 1-24 |
| A | CN 104037181 A (INFINEON TECHNOLOGIES AG) 10 September 2014 (2014-09-10) entire document | 1-24 |
| A | CN 109564277 A (SOFTKINETIC SENSORS NV) 02 April 2019 (2019-04-02) entire document | 1-24 |
| A | CN 108566524 A (SHENZHEN GUANGWEI TECHNOLOGY CO., LTD.) 21 September 2018 (2018-09-21) entire document | 1-24 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **22 May 2020** | **09 June 2020** |

| Name and mailing address of the ISA/CN | Authorized officer |
|---|---|
| China National Intellectual Property Administration (ISA/CN)<br>No. 6, Xitucheng Road, Jimenqiao Haidian District, Beijing 100088<br>China | |
| Facsimile No. (86-10)62019451 | Telephone No. |

Form PCT/ISA/210 (second sheet) (January 2015)

International application No.

**PCT/CN2019/105235**

| Patent document cited in search report | | | Publication date (day/month/year) | Patent family member(s) | | | Publication date (day/month/year) |
|---|---|---|---|---|---|---|---|
| CN | 102376728 | A | 14 March 2012 | US | 8687174 | B2 | 01 April 2014 |
| | | | | DE | 102011079589 | A1 | 16 February 2012 |
| | | | | US | 2012038904 | A1 | 16 February 2012 |
| | | | | CN | 102376728 | B | 09 September 2015 |
| CN | 107958914 | A | 24 April 2018 | US | 10541261 | B2 | 21 January 2020 |
| | | | | DE | 102017202754 | A1 | 19 April 2018 |
| | | | | US | 2018108692 | A1 | 19 April 2018 |
| CN | 109346553 | A | 15 February 2019 | | None | | |
| US | 2016005913 | A1 | 07 January 2016 | US | 2019044019 | A1 | 07 February 2019 |
| | | | | US | 10121928 | B2 | 06 November 2018 |
| CN | 104037181 | A | 10 September 2014 | US | 2018151765 | A1 | 31 May 2018 |
| | | | | US | 2014145281 | A1 | 29 May 2014 |
| | | | | US | 9905715 | B2 | 27 February 2018 |
| | | | | US | 2017358697 | A1 | 14 December 2017 |
| | | | | CN | 104037181 | B | 23 November 2018 |
| | | | | US | 10008621 | B2 | 26 June 2018 |
| | | | | DE | 102013018789 | A1 | 05 June 2014 |
| CN | 109564277 | A | 02 April 2019 | EP | 3497470 | A1 | 19 June 2019 |
| | | | | BE | 1025050 | A1 | 05 October 2018 |
| | | | | US | 2019187260 | A1 | 20 June 2019 |
| | | | | WO | 2018029369 | A1 | 15 February 2018 |
| | | | | BE | 1025050 | B1 | 12 October 2018 |
| CN | 108566524 | A | 21 September 2018 | | None | | |